(19) **Europäisches Patentamt / European Patent Office / Office européen des brevets**

(11) **EP 1 783 643 A1**

(12) **EUROPEAN PATENT APPLICATION**
published in accordance with Art. 158(3) EPC

(43) Date of publication:
 **09.05.2007 Bulletin 2007/19**

(51) Int Cl.:
 ***G06F 17/50*** (2006.01)

(21) Application number: **05765800.7**

(86) International application number:
 **PCT/JP2005/012892**

(22) Date of filing: **13.07.2005**

(87) International publication number:
 **WO 2006/009026 (26.01.2006 Gazette 2006/04)**

(84) Designated Contracting States:
 **CH DE LI**

(30) Priority: **16.07.2004 JP 2004210858**

(71) Applicant: **Kyoto University**
 **Kyoto-shi, Kyoto 606-8501 (JP)**

(72) Inventors:
 • **YAMASHITA, Shinsuke**
  **c/o Graduate School of Eng.**
  **Kyoto-shi,**
  **Kyoto 6068501 (JP)**
 • **KOBAYASHI, Masakazu**
  **c/o Graduate School of Eng.**
  **Kyoto-shi,**
  **Kyoto 6068501 (JP)**
 • **NISHIWAKI, Shinji**
  **c/o Graduate School of Eng.**
  **Kyoto-shi,**
  **Kyoto 6068501 (JP)**

 • **IZUI, Kazuhiro**
  **c/o Graduate School of Eng.**
  **Kyoto-shi,**
  **Kyoto 6068501 (JP)**
 • **YOSHIMURA, Masataka**
  **c/o Graduate School of Eng.**
  **Kyoto-shi,**
  **Kyoto 6068501 (JP)**
 • **TOMITA, Naohide**
  **c/o Graduate School of Eng.**
  **Kyoto-shi,**
  **Kyoto 6068501 (JP)**

(74) Representative: **Hoffmann, Jörg Peter**
 **Müller Hoffmann & Partner**
 **Patentanwälte**
 **Innere Wiener Strasse 17**
 **81667 München (DE)**

(54) **OPTIMUM DESIGN SUPPORT DEVICE, OPTIMUM SETTING SUPPORT METHOD, AND OPTIMUM DESIGN SUPPORT PROGRAM**

(57)    The optimal design support system is to design a structure that outputs a desired load or displacement to a portion by using elastic deformation when a load or displacement is applied to a predetermined portion. More specifically, the optimal design support system comprises a structure creating part 11 that creates a structure FM as being an integrated structure of multiple mutually different types of elements by changing a material layout within a design domain D so as to minimize the difference between the output load or displacement and the desired load or displacement and to maximize the stiffness of the object globally, an initial shape setting part 12 that sets a feasible initial shape IS corresponding to the function of each element which forms the structure FM, and a shape changing part 13 that changes the initial shape IS so as to minimize the difference between the displacement, the load, a related stress or a related strain and a predetermined target value within a range where any parts of the initial shape IS deforms elastically.

FIG.2

EP 1 783 643 A1

**Description**

**FIELD OF THE ART**

This invention relates to an optimal design support system, an optimal design support method and an optimal design support program for designing an object that outputs a desired load or displacement to a portion by using elastic deformation when a load or displacement is applied to a predetermined portion.

**BACKGROUND ART**

Recently, methods for designing an object (hereinafter called as a compliant mechanism) that outputs a desired load or displacement to a portion by using elastic deformation when a load or displacement is applied to a predetermined portion have been proposed.

Among them, there is a method for designing the compliant mechanism by a shape optimization procedure. Since it is possible for the shape optimization procedure to quantitatively deal a local physical quantity such as a displacement amount or stress quantitatively as a design variable, there is a feature that a concrete shape can be designed. However, since a performance of the compliant mechanism varies according to a layout of a portion having flexibility more than a predetermined level, there is a problem that a trial and error depending on designer's intuition or experiences when determining its initial shape can not be avoided.

In addition, there is a method for creating and designing the compliant mechanism by the topology optimization procedure. As described in a non-patent document 1 and a non-patent document 2, this method using the topology optimization procedure has a feature that the optimal structure of the compliant mechanism can be obtained without any trial and error. However, in creating and designing the compliant mechanism by the use of the topology optimization procedure there is a problem that a hinge structure is generated as a result of maximizing the flexibility in a calculative manner. Since this structure is practically impossible to manufacture, it has been considered that the object containing the hinge structure obtained as a result of the topology optimization procedure has to be avoided. Furthermore, a topology optimization procedure considering a large deformation analysis is presented in order to evaluate a performance of the compliant mechanism quantitatively during a process of optimization. However, with this procedure, it takes huge amounts of time for a process of optimal design and there is a possibility that a physically meaningless local solution is obtained as an optimal solution. In addition, even though the obtained solution of the optimal structure is physically meaningful, it is not so different from a case where the large deformation is not considered. As a result, it is not necessarily the best plan to consider the large deformation analysis for the topology optimization.

Meanwhile, as described in a non-patent document 3, there is a method that an optimal structure is determined for an object by the use of the topology optimization procedure and then the optimal structure is formed into a detailed shape by the use of the shape optimization procedure. However, since this method can be applied only to a stiffness maximization problem which aims to improve stability of the object, there is a problem that this method can not deal with the hinge structure that is generated when the topology optimization procedure is used if applied to a design of the compliant mechanism.

Non-patent document 1: Nishiwaki, S., Min, S., Yoo, J., and Kikuchi, N.,: Optimal Structural Design Considering Flexibility, Comput. Methods Appl. Mech. Engrg, 190 (2001), 4457-4504.
Non-patent document 2: Sigmund O.: On the Design of Compliant Mechanisms Using Topology Optimization, Mech. Struct. & Mach., 254, (1997) 493.
Non-patent document 3: Hisashi Ihara, Masatoshi Shimoda, Hideyuki Azegami, Toshiaki Sakurai, Shape Design by Integrating Shape Optimization with Topology Optimization for Multiobjective Structures (An Approach Using Homogenization Method and Traction Method), Japan Society of Mechanical Engineers (A canto) 62 596, pp1091 - 1097.
Non-patent document 4: Chirehdast, M., Gea, H-D., Kikuchi N., and Papalambros, P. Y.: Structural Configuration Examples of an Integrated Optimal Design Process, J. Mech. Design, Trans. ASME, 116, (1994), 997

**DISCLOURE OF THE INVENTION**

**PROBLEMS TO BE SOLVED BY THE INVENTION**

Then the present claimed invention changes in thinking and devises a following means to solve the above-mentioned problems at once. More specifically, an object of the present claimed invention is to make it possible to design a practical compliant mechanism by the use of the topology optimization procedure and the shape optimization procedure by creating an integrated structure of multiple mutually different types of elements featuring a compliant mechanism by the use of the topology optimization procedure, then securing and making the most use of a performance of mutually different types of elements and setting an initial shape of shape optimization.

**DEVICES TO SOLVE THE PROBLEM**

More specifically, the optimal design support system in accordance with this invention is to design an object that outputs a desired load or displacement to a portion by using elastic deformation when a load or displacement is applied to a predetermined portion, and is characterized by comprising a design domain data storing part that stores a design domain data which is a data to set a design domain of the object and an initial material layout within the design domain, a structure creating part that changes the material layout within the design domain and creates a structure which has a specified function as being an integrated structure of multiple mutually different types of elements which represents a specified function so as to minimize the difference between the output load or displacement and the desired load or displacement and maximize the stiffness of the object globally, an initial shape setting part that sets a feasible initial shape corresponding to the function of the elements for the respective elements which form the structure, and a shape changing part that changes the initial shape so as to minimize the difference between the displacement, the load, a related stress or a related strain and a predetermined target value within a range where any parts of the initial shape deform elastically.

In accordance with this arrangement, it is possible to create the integrated structure of multiple mutually different types of elements featuring the compliant mechanism and then to design a detailed shape that can be actually manufactured with taking advantage of the mutually different types of elements. As a result of this, it is possible to design a practical compliant mechanism by making use of the hinge element that has been considered to be avoided.

In order to design a high-function and high performance compliant mechanism, it can be conceived to create a mechanism that can not be created by the above-mentioned structure creating part and that is based on an idea of a designer, or to combine multiple compliant mechanisms. In order to make this possible, it is preferable to further comprise a nonlinear structure data storing part that stores a nonlinear structure data showing a nonlinear structure that behaves to deform nonlinearly and that can not be created by the structure creating part, and the initial shape setting part sets the initial shape by combining the structure and the nonlinear structure. Alternatively, it is preferable that the initial shape setting part sets the initial shape by combining multiple structures created by the structure creating part. The nonlinear structure includes a buckling structure that makes a buckling deformation or a structure having a ratchet mechanism.

With this arrangement, it is possible to provide each portion with an optimal feature. In addition, since a compliant mechanism comprising multiple components can also be designed, it is possible to provide multiple functions by changing a material of each component or exchanging a component if necessary.

Furthermore, it is preferable that the initial shape setting part sets mutually different design variables as a reference to change a shape on the mutually different types of element and sets the initial shape based on the design variables, and the shape changing part changes the initial shape by updating the design variables.

With this arrangement, since the initial shape is set with setting the design variables for each element, it is possible to set the initial shape with securing a property of each element accurately. Furthermore, it is possible to set the design variables preferably when compared with a case wherein the design variables are set arbitrarily, thereby to lessen a number of the design variables. As a result of this, it is possible to shorten time required for changing the initial shape.

As a concrete embodiment, it is preferable that the structure creating part creates the structure by the use of a topology optimization procedure.

In addition, it is preferable that the shape changing part changes the initial shape by the use of a shape optimization procedure.

With this arrangement, it is possible to design a practical compliant mechanism by the use of a universally known procedure. As a result, it is possible to provide an optimal design support system to design a compliant mechanism using the topology optimization procedure and the shape optimization procedure.

More concretely, it is preferable that the structure creating part creates two kinds of elements as said elements; one is a hinge element whose stiffness is generally zero and the other is a lump element which is other portions of the hinge element.

In addition, it is more effective if the structure creating part further creates a flexible element as being a portion having stiffness smaller than a predetermined stiffness in the lump element as the element.

The hinge element is an element whose stiffness is generally zero and that can not be manufactured practically. In addition, the flexible element is a portion whose width is relatively small in the lump element or a portion (a gray scale portion) whose normalized density is larger than 0 and smaller than 1 with the maximum value of an element density set as a reference.

As a concrete embodiment to set the initial shape, it is preferable that the initial shape setting part sets a design variable in a width direction of the hinge element, sets a width at a predetermined location of the lump element as another design variable, sets a control point based on the design variables, and sets the initial shape based on the control point.

In order to set the initial shape more accurately, it is preferable that the initial shape setting part sets a design variable in a width direction of the flexible element in the structure.

Furthermore, since the performance of the compliant mechanism depends on a location of the hinge element and the flexible element, it is preferable that the initial shape setting part sets the location of the control point based on the design variables set on the hinge element and the flexible element as the design variable.

In addition, not only the location of the control point but also an angle or a curvature radius of the control point can be set as a design variable depending on a kind of the control point.

## EFFECTS OF THE INVENTION

As mentioned above, in accordance with this invention, it is possible to create the integrated structure of multiple different types of elements which represents a specified function and features the compliant mechanism and to design the detailed optimal shape that can actually be manufactured with taking advantage of the mutually different types of elements. As a result of this, it is possible to design a practical compliant mechanism without compelling a designer to conduct trial and error processes in case of setting the initial shape by making use of the hinge element that has been considered to be avoided.

## BRIEF DESCRIPTION OF THE DRAWINGS

Fig. 1 is a functional block diagram showing a structure of an optimal design support system in accordance with a first embodiment of this invention.

Fig. 2 is a functional block diagram of the optimal design support system in accordance with this embodiment.

Fig. 3 is a flow chart showing a performance of the optimal design support system in accordance with this embodiment.

Fig. 4 is a view showing a design domain of a topology optimization in accordance with this embodiment.

Fig. 5 is a view showing a distribution of a shape function used for the topology optimization in accordance with this embodiment.

Fig. 6 is a view showing a hexagonal micro structure used for the topology optimization in accordance with this embodiment.

Fig. 7 is a view showing a boundary condition for formulating a compliant mechanism in accordance with this embodiment.

Fig. 8 is a view showing the boundary condition for formulating a compliant mechanism in accordance with this embodiment.

Fig. 9 is a view showing the boundary condition for formulating a compliant mechanism in accordance with this embodiment.

Fig. 10 is a flow chart showing an optimization algorithm of the topology optimization in accordance with this embodiment.

Fig. 11 is a general view showing a hinge element and a lump element in the optimal structure.

Fig. 12 is a view showing a way to arrange design variables and a spline curve in accordance with this embodiment.

Fig. 13 is a view showing a design condition of a step Sa4 in accordance with this embodiment.

Fig. 14 is a flow chart showing an optimization algorithm of a shape optimization in accordance with this embodiment.

Fig. 15 is a photograph of a clip forceps for medical use.

Fig. 16 is a photograph of a clip for medical use.

Fig. 17 is a photograph of a state that the forceps are pinched by the clip.

Fig. 18 is an enlarged photograph of a link part of the forceps.

Fig. 19 is a view showing a design domain in accordance with this embodiment.

Fig. 20 is a view showing a distal end portion of the design domain in accordance with this embodiment.

Fig. 21 is a view showing an optimal structure in accordance with this embodiment.

Fig. 22 is a view showing an arrangement of the design variables in accordance with this embodiment.

Fig.23 is a view showing an initial shape in accordance with this embodiment.

Fig. 24 is a view showing an optimal shape in accordance with this embodiment.

Fig. 25 is a view showing a value of a final objective function and values of each design variable and each constraint condition in accordance with this embodiment.

Fig. 26 is a view showing a movement of the objective function in accordance with this embodiment.

Fig. 27 is a photograph of forceps manufactured in this embodiment.

Fig. 28 is a photograph of a state that the clip is really picked by the use of the forceps manufactured in this embodiment.

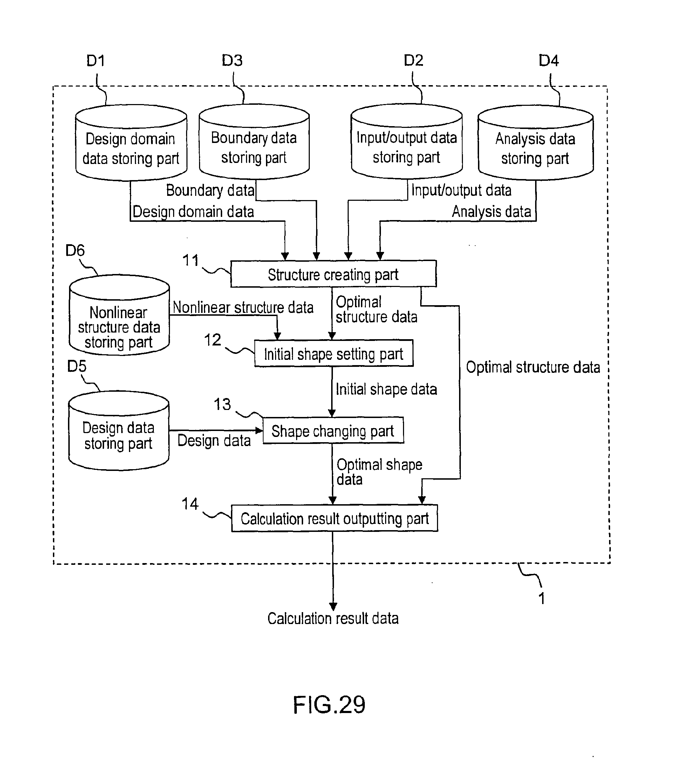

Fig. 29 is a functional block diagram showing a structure of an optimal design support system in accordance with a second embodiment.

Fig. 30 is a flow chart showing a performance of the optimal design support system in accordance with this embodiment.

Fig. 31 is a flow chart showing a detailed performance of the optimal design support system in accordance with this embodiment.

Fig. 32 is a view showing a tree structure of a session in an idea generation support system in accordance with this embodiment.

Fig. 33 is a hierarchical structure showing a relationship between a goal, an approach and an idea in the idea generation support system in accordance with this embodiment.

Fig. 34 is a modified diagram showing a gripper to which a stopper mechanism is added.

Fig. 35 is a view showing a flow of a first stage visualized by the use of the session in the second embodiment.

Fig. 36 is a hierarchical structure showing a flow of a first stage visualized by the use of the session in accordance with this embodiment.

Fig. 37 is a view showing a concept of the gripper in accordance with this embodiment.

Fig. 38 is a view showing a detail of an optimal structure of the gripper in accordance with this embodiment.

Fig. 39 is a view showing a detail of a stopper in accordance with this embodiment.

Fig. 40 is a view showing an arrangement of design variables in accordance with this embodiment.

Fig. 41 is a view showing an arrangement of design variables of the stopper in accordance with this embodiment.

Fig. 42 is a view showing an initial shape in accordance with this embodiment.

Fig. 43 is a view showing an optimal shape in accordance with this embodiment.

Fig. 44 is a view showing a relationship between a displacement amount and a reaction force $F_{in}$ at an input point $P_{in}$ in accordance with this embodiment.

## BEST MODES OF EMBODYING THE INVENTION

A first embodiment of the present claimed invention will be explained with reference to drawings.

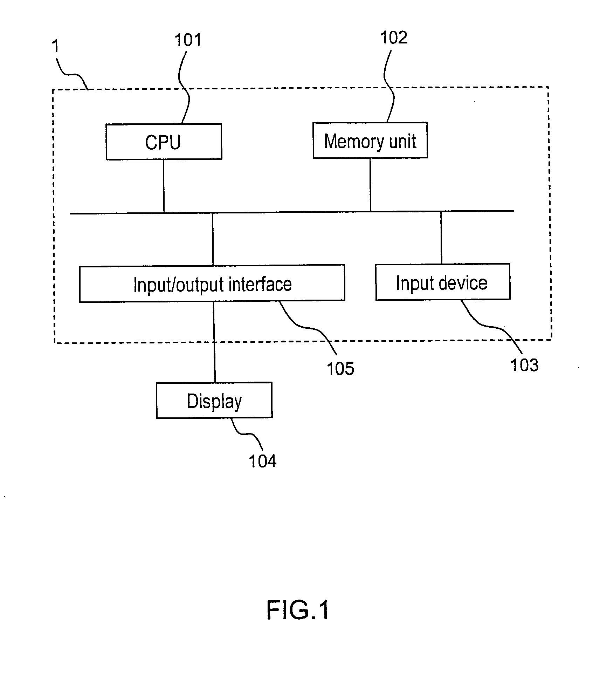

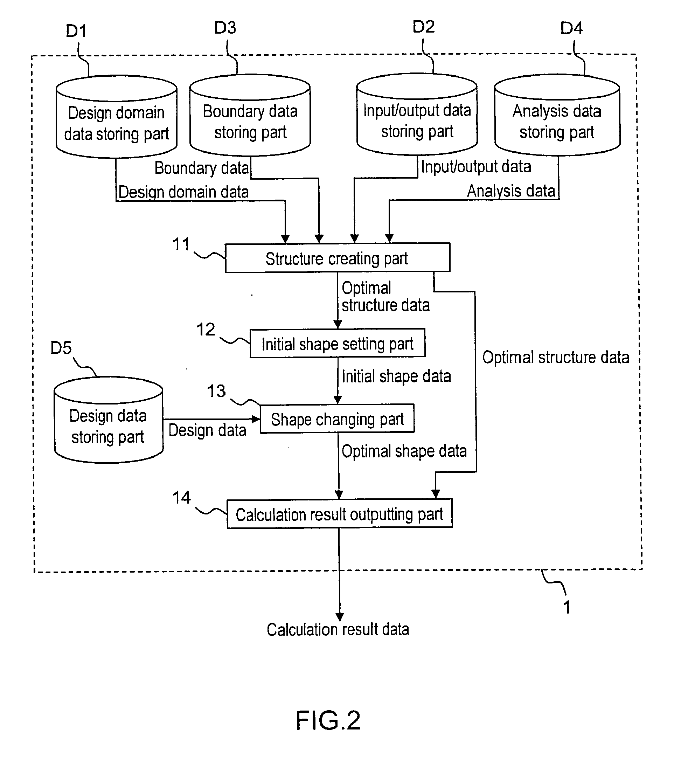

An optimal design support system 1 in accordance with the first embodiment is to design an object that outputs a desired load or displacement to a portion by using elastic deformation when a load or displacement applied to a predetermined portion, and as shown in Fig. 2, comprises a design domain data storing part D1 that stores a design domain data that sets a design domain $\underline{D}$ of the object and an initial material layout within the design domain $\underline{D}$, an input/output data storing part D2 that stores an input/output data that shows a location and a direction of the input and the output, a boundary data storing part D3 that stores a boundary data as being a data concerning a boundary condition of the design domain $\underline{D}$, an analysis data storing part D4 that stores an analysis data as being a material constant or the like, a structure creating part 11 that creates a structure $\underline{FM}$ which has a specified function as being a integrated structure of multiple mutually different types of elements which represents a specified function by changing the material layout within the design domain $\underline{D}$ so as to minimize the difference between the output load or displacement and the desired load or displacement and to maximize the stiffness of the object globally, an initial shape setting part 12 that sets a feasible initial shape $\underline{IS}$ corresponding to the function of each element forming the structure $\underline{FM}$, a real design data storing part D5 that stores a design condition of a shape changing part 13, the shape changing part 13 that changes the initial shape $\underline{IS}$ so as to minimize the difference between the load, the displacement, a related stress or a related strain and a predetermined target value within a range where any parts of the initial shape $\underline{IS}$ deform elastically, and a calculation result outputting part 14 that outputs calculation results of the structure creating part 11 and the shape changing part 13. As shown in Fig. 1, the optimal design support system 1 is a general purpose or dedicated purpose computer comprising a CPU 101, a memory device 102 such as a volatile memory or an HDD, an input device 103 such as a mouse or a keyboard, and an input/output interface 105 to be connected with an output device 104 such as a display or a printer to output an analysis model or a calculation result. As shown in a functional block diagram of Fig. 2, the optimal design support system 1 is so arranged to exercise functions as the design domain data storing part D1, the input/output data storing part D2, the boundary data storing part D3, the analysis data storing part D4, the structure creating part 11, the initial shape setting part 12, the real design data storing part D5, the shape changing part 13, and the calculation result outputting part 14 by installing a predetermined program on the memory device 102 and making the CPU 101 and peripheral devices cooperate based on the program.

Each component will be described in detail.

The design domain data storing part D1 stores the design domain data that sets the design domain $\underline{D}$ to design a predetermined compliant mechanism and the initial material layout within the design domain $\underline{D}$.

The input/output data storing part D2 stores the data that sets the location and direction of the input to the design domain $\underline{D}$ stored in the design domain data storing part D1 and the location and direction of the desired output for the input.

The boundary data storing part D3 stores the data concerning the boundary condition of the design domain D.

The analysis data storing part D4 stores the analysis data as being a material constant such as a condition value of constraint necessary for constraining a volume used at a time of obtaining the structure FM and a value of a Young's modulus or a Poisson's ratio necessary for analyzing a displacement field.

The structure creating part 11 extracts the design domain data, the input/output data, the boundary data and the analysis data from the boundary data storing part D1, the input/output data storing part D2, the boundary data storing part D3 and the analysis data storing part D4, and creates the structure FM which has a specified function as being an integrated structure of multiple mutually different types of elements which represents a specified function by changing the material layout within the design domain D based on these data by the use of the topology optimization procedure so as to minimize the difference between the output load or displacement and the desired load or displacement and to maximize the stiffness of the object globally.

The initial shape setting part 12 sets the feasible initial shape IS so as to secure a feature of the function for each element of the structure FM created by the structure creating part 11.

More concretely, the design variable is set in a width direction of a hinge element 111 whose stiffness is generally zero resulting from maximization of flexibility so as both to meet the stress constraint and to secure sufficient flexibility, and a width of a predetermined location of a lump element 112 as being a portion other than the hinge element 111 is set as the design variable. Then both ends of each design variable are set as control points and the initial shape IS is set by connecting the control points with an interpolation curve so as not to cross the interpolation curve.

In addition, an interpolation curve such as a spline curve or the Bezier curve that is generally used can be used as the interpolation curve.

The real design data storing part D5 stores the design condition of the shape changing part 13.

The shape changing part 13 changes the initial shape IS by updating the set design variables based on the design condition stored in the real design data storing part D5 by the use of a shape optimization procedure.

The calculation result outputting part 14 outputs a calculation result of the structure creating part 11 and a calculation result of the shape changing part 13. To output the calculation results means to display the result on the display 104 in this embodiment.

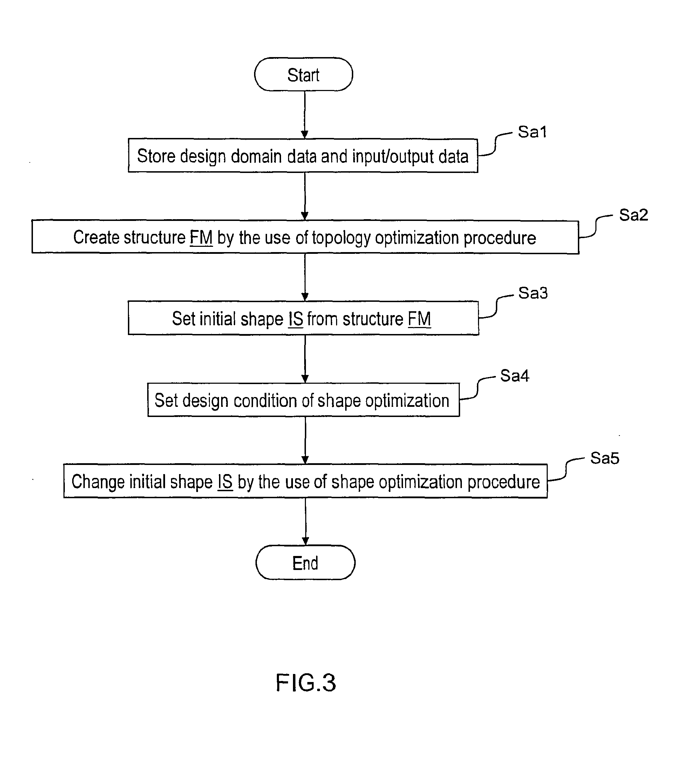

Next, a performance of the optimal design support system 1 of the above arrangement will be explained with reference to Fig. 3. The structure FM obtained by the use of the topology optimization procedure in the structure creating part 11 is called as an optimal structure FM, and a shape obtained after changing the initial shape IS by the use of the shape optimization procedure in the shape changing part 13 is called as an optimal shape OS.

First, an operator operates the input device 103 in order to input the design domain data, the input/output data, the boundary data and the analysis data.

Each data input with the above operation is received by a data receiving part (not shown in drawings) and the design domain data is stored in the design domain data storing part D1, the input/output data is stored in the input/output data storing part D2, the boundary data is stored in the boundary data storing part D3, and the analysis data is stored in the analysis data storing part D4 (step Sa1).

Next, the structure creating part 11 creates the optimal structure FM by the use of the topology optimization procedure (step Sa2).

Then, the initial shape setting part 12 sets the initial shape IS of the shape optimization from the optimal structure FM created by the structure creating part 11 (step Sa3).

Next, the operator operates the input device 103 in order to input a quantitative design condition of the shape changing part 13.

The design condition with the above operation is received by the data receiving part (not shown in drawings) and stored in the real design data storing part D5 (step Sa4). This may be previously stored.

Then the shape changing part 13 changes the initial shape IS by the use of the shape optimization procedure and the optimal shape OS is obtained (step Sa5).

Each step Sa1 ~ Sa5 will be explained.

<Step Sa1> Store of the design domain data, the boundary condition data, the input/output data and the analysis data

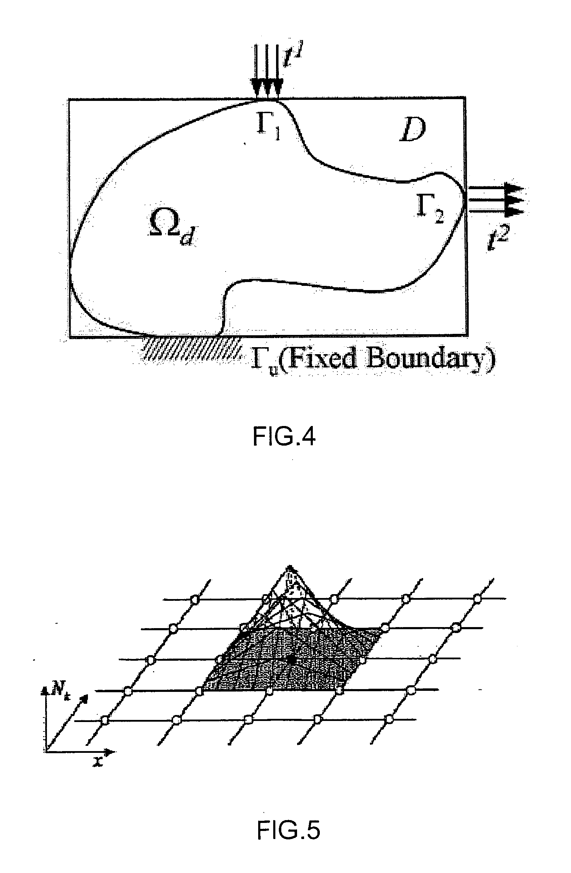

Directions (locations and directions of the input and the output) of the design domain D, the boundary condition, and the flexibility to be added are determined as a preliminary step of the topology optimization. More specifically, as shown in Fig. 4, the design domain D including an area $\Omega_d$ to be the optimal structure FM is first set, and then a traction (input) $t^1$ applied to the compliant mechanism and its boundary $\Gamma_1$ and a traction (output) $t^2$ that shows a fictitious dummy load showing a direction to which the structure deforms in order to fulfill a function of its mechanism and its boundary $\Gamma_2$ are set in the design domain D. Furthermore, the condition value of the constraint necessary for constraining a volume used at a time of creation and design by the topology optimization procedure and the Young's modulus and the Poisson's ratio necessary for analyzing a displacement field are also set.

<Step Sa2> Creation of the optimal structure FM by the use of the topology optimization procedure

The topology optimization is conducted according to the design condition and the design domain D set at the step Sa1. An object of the step Sa2 is to obtain an optimal topology of the compliant mechanism and a general shape (optimal structure FM) that realize a predetermined input/output relationship.

<Relaxation method of a design space where continuity of a material distribution is assumed>

As mentioned above, several methods have been proposed as a method for creating the compliant mechanism by the use of the topology optimization. A method based on a homogenization method described in a non-patent document 1 or a method based on an SIMP (Solid Isotropic Material with Penalization) method described in a non-patent document 2 can be represented as its representative methods. With these methods, however, since the design variables are set independently for each element in case of digitization by a finite element method, discontinuity between elements is generated and this becomes a cause of numerical instability problems represented by a checkerboard patterns. Several methods such as a filtering procedure are proposed as a method to solve these problems, however, these methods can not be a drastic solution. Then in this embodiment in order to solve the problems fundamentally, the topology optimization is conducted based on the relaxation method of the design space where the continuity of the material distribution is assumed.

In this method, the homogenization method is used for relaxation of the design space. In digitizing approximation of the design domain D by the finite element method, a microstructure, namely a design variable is arranged not on each finite element but on each node. The design variable is assumed to be a continuous function more than or equal to $C^0$ in the design domain D and the design variable r(x) at a certain location x in the design domain D is digitized as follows by the use of a shape function vector M(x) whose structure element is the shape function $N_J(x)$ (J=1, $\cdots$, n).

[Equation 1]

$$r \approx r^h = M(x)R = N_1 R_1 + N_2 R_2 + \cdots + N_J R_J + \cdots + N_n R_n$$

Where R stands a design variable vector at a node, n indicates a number (a total number of nodes in the design domain D) of the design variable. In this case, as shown in Fig. 5, since the shape function corresponding to the "J"th node changes continuously in its related elements (four elements in case of Fig. 5), an unstable problem generating on $C^{-1}$-continuity such as a checkerboard pattern can be avoided. In this embodiment, the bi-linear function is used as the most simple shape function having $C^0$-continuity.

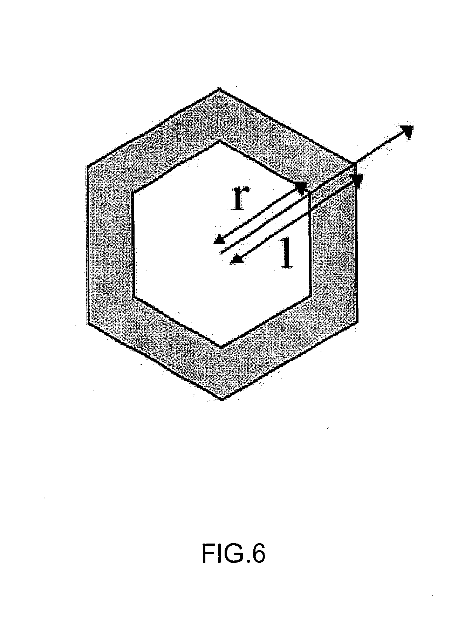

In addition, a hexagonal structure of Fig. 6 showing an isotropic behavior is used as a microstructure utilized in relaxation of the design space. Where, the design variable is a representative length r of a hole shown in Fig. 6.

<Formulation of compliant mechanism design>

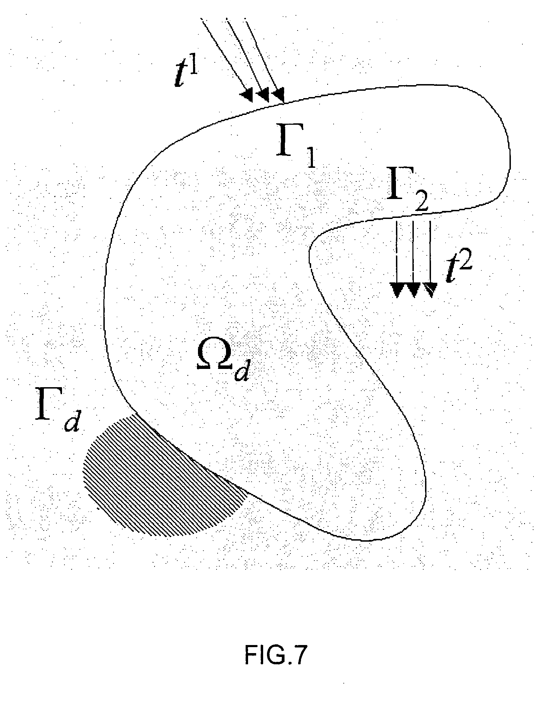

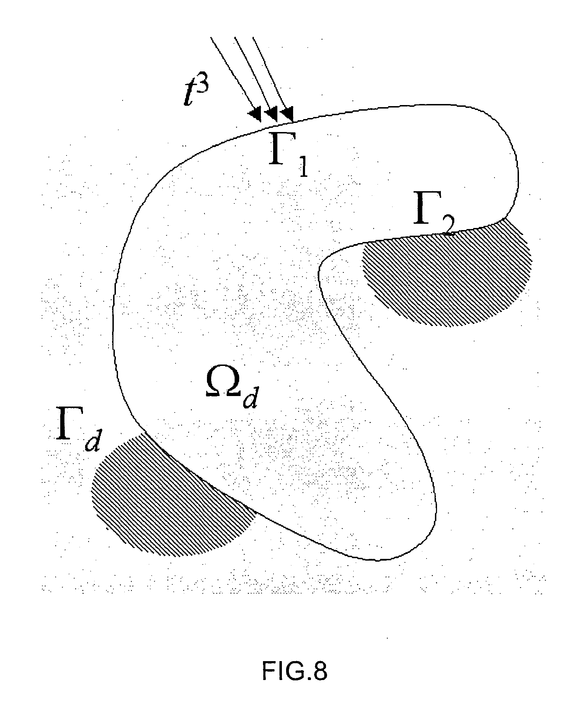

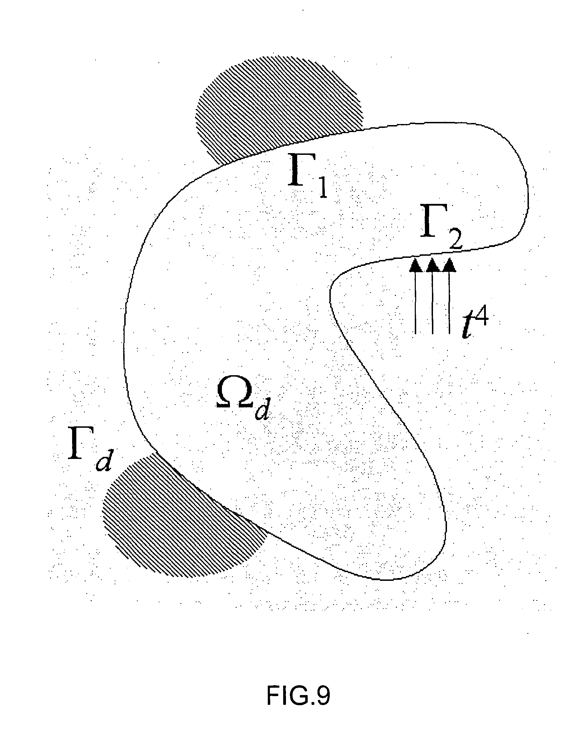

Next, a design requirement of the compliant mechanism is clarified and the optimization problem is formulated based on the design requirement. As shown in Fig. 7 - Fig. 9, a design problem of the compliant mechanism is considered where a boundary $\Gamma_2$ deforms toward a direction specified by a dummy load $t^2$ at a time when a traction $t^1$ is applied to a boundary $\Gamma_1$ of an area $\Omega_d$ whose boundary $\Gamma_d$ is fixed. At this time, as the design requirement of the compliant mechanism it is represented to secure the flexibility and stiffness shown as follows. More specifically, the flexibility is mechanical flexibility wherein the boundary $\Gamma_2$ can obtain the maximum displacement toward the direction specified by the dummy load $t^2$ as shown in Fig. 7, and the stiffness is stiffness wherein the shape can be maintained although the traction $t^1$ is applied to the compliant mechanism as shown in Fig. 8 or a reaction force from a target object such as a workpiece is applied to the compliant mechanism as shown in Fig. 9.

In this case, sufficient flexibility shown in Fig. 7 can be obtained by maximizing the mutual mean compliance formulated by the following equation 2 with the dummy load $t^2$ per unit at the boundary $\Gamma_2$ and a displacement field $u^1$ of the object to be designed while the traction $t^1$ is applied to the boundary $\Gamma_1$.

[Equation 2]

$$l^2(u^1) = \int_{\Gamma_2} t^2 \cdot u^1 d\Gamma$$

On the other hand, sufficient stiffness in case the traction $t^3=t^1$ is applied as shown in Fig. 8 can be obtained by minimizing the mean compliance formulated by the following equation 3 with a displacement field $u^3$ of the object to be designed while the boundary $\Gamma_2$ is fixed.

[Equation 3]

$$l^3(u^3) = \int_{\Gamma_1} t^3 \cdot u^3 d\Gamma$$

Similarly, sufficient stiffness in case the reaction force from the target object is imposed as shown in Fig. 9 can be obtained by minimizing the mean compliance defined by the following equation 4 with a displacement field $u^4$ of the object to be designed while the boundary $\Gamma_1$ is fixed, a direction of the reaction force imposed at the boundary $\Gamma_2$ is assumed to be opposite to that of the dummy load $t^2$ and $t^4=-t^2$ is applied.

[Equation 4]

$$l^4(u^4) = \int_{\Gamma_2} t^4 \cdot u^4 d\Gamma$$

As mentioned above, in order to obtain the optimal structure FM that meets the design requirement regarding the flexibility shown in Fig. 7 and the stiffness shown in Fig. 8 and Fig. 9, the optimization problem is formulated as the following equation 5.

[Equation 5]

$$\underset{\Gamma}{\text{maximize}}\, l^2(u^1) = \int_{\Gamma_2} t^2 \cdot u^1 d\Gamma, \underset{\Gamma}{\text{minimize}}\, l^3(u^3) = \int_{\Gamma_1} t^3 \cdot u^3 d\Gamma,$$
$$\text{and} \quad \underset{\Gamma}{\text{minimize}}\, l^4(u^4) = \int_{\Gamma_2} t^4 \cdot u^4 d\Gamma$$

Constraint condition

[Equation 6]

$$t^3 = t^1$$

[Equation 7]

$$t^4 = -t^2$$

[Equation 8]

$$a(u^1, v^1) = l^1(v^1) \text{ for } u^1 \in V^1 \; \forall v^1 \in V^1$$

[Equation 9]

$$a(u^2, v^2) = l^2(v^2) \text{ for } u^1 \in V^2 \; \forall v^2 \in V^1$$

[Equation 10]

$$a(u^3, v^3) = l^3(v^3) \text{ for } u^3 \in V^3 \; \forall v^3 \in V^3$$

[Equation 11]

$$a(u^4, v^4) = l^4(v^4) \text{ for } u^4 \in V^4 \; \forall v^4 \in V^4$$

[Equation 12]

$$0 \leq r \leq 1$$

[Equation 13]

$$g(r) = \int_{\Omega_d} \rho d\Omega - \Omega_s = \int_D \rho d\Omega - \Omega_s \leq 0$$

Where each of $V^1$, $V^2$, $V^3$, $V^4$ is a virtual displacement vector, $\varepsilon$ is a strain tensor, $\underline{D}$ is an elastic tensor, $\underline{W}_s$ is an upper limit value of a volume constraint, and $a(u,v) = \int_\Omega \varepsilon(v)^T D\varepsilon(u) d\Omega$. In addition, $V^1 = \{v = v_i e_i : v = 0 \text{ on } \Gamma_d\}$, $V^3 = \{v = v_i \bar{e}_i : v = 0 \text{ on } \Gamma_d \text{ and } \Gamma_2\}$, $V^4 = \{v = v_i e_i : v = 0 \text{ on } \Gamma_d \text{ and } \Gamma_1\}$.

In order to solve the multipurpose optimization problem, the following objective function is set. The equation 14 has a function that the multipurpose objective function itself adjusts a weight concerning each objective function by formulating the mutual mean compliance and the mean compliance in a form of multiplication or division.

[Equation 14]

$$\underset{r}{\text{maximize}} \, f_1 = \frac{l^2(u^1)}{w_3 l^3(u^3) + w_4 l^4(u^4)}$$

Where each of $w_3$ and $w_4$ is a weighting coefficient.

<Optimization algorithm>

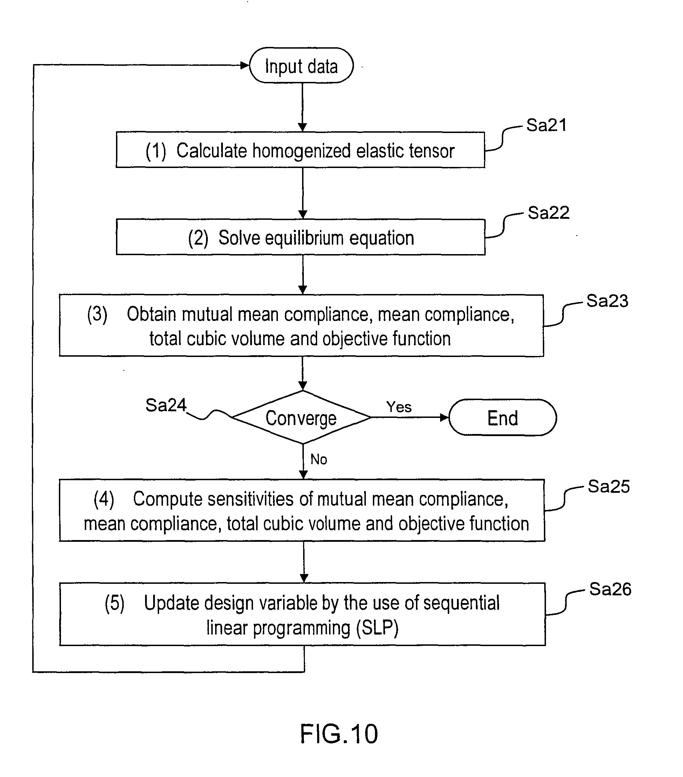

A flowchart of the topology optimization is shown in Fig. 10. First, (1) a homogenized elasticity tensor is computed (step Sa21). Next, (2) a displacement field is obtained by solving an equilibrium equation (step Sa22). (3) Each value of the mutual mean compliance, the mean compliance, the total cubic volume, and the objective function are obtained by the use of the displacement field (step Sa23). If the objective function converges, the algorithm terminates (step Sa24). If not, (4) the sensitivities of the mutual mean compliance, the mean compliance, the total cubic volume, and the objective function are computed (step Sa25). By the use of the sensitivity (5) the design variable is updated by the use of the Sequential Linear Programming (SLP), and the procedure returns to the step Sa21 (step Sa26).

<Step Sa3> Set of the initial shape IS from the optimal structure FM

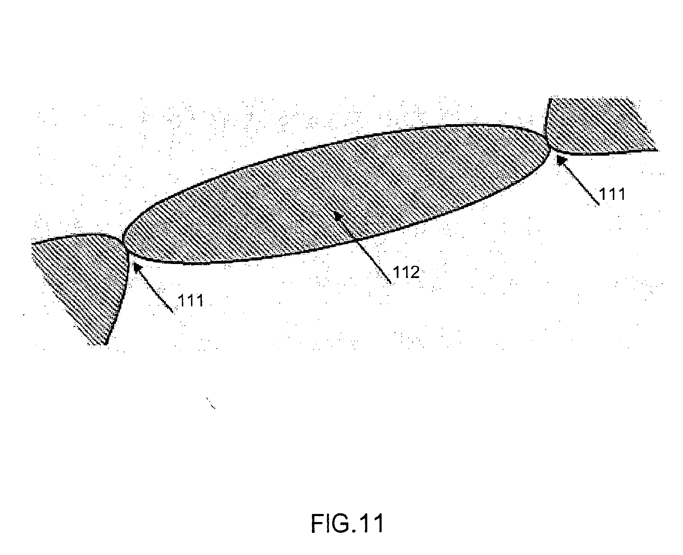

The initial shape IS necessary for shape optimization is set from the optimal structure FM by means of the topology optimization obtained in the step Sa2. Several methods have been presented as a method for setting the initial shape IS. As a representative method there is an image conversion method described in a non-patent document 4. With this method, the initial shape IS of the shape optimization is obtained by image conversion of the optimal structure FM obtained by the topology optimization and smoothing of the boundary. However, with this method, since the optimal structure FM is converted without a mechanical consideration concerning a performance of the structure, it is difficult to apply this method to a case that a structure has a portion that is representative of a performance such as the optimal structure FM of the compliant mechanism. This is because of the following reason. Usually two performances considered at a stage of the optimization, namely, the hinge element 111 and the lump element 112 featuring the flexibility and the stiffness are generated for the optimal structure FM of the compliant mechanism as shown in Fig. 11. Since the image conversion method does not make considerations concerning these features, there is a possibility that the initial shape IS set by the image conversion method loses two features.
With this embodiment, the shape optimization is executed with the two performances kept after the initial shape IS is set by allocating the design variables to the hinge element 111 and the lump element 112 featuring two performances that are considered at a time of topology optimization, namely, the flexibility and the stiffness. Its procedures are shown as follows.

(1) Allocation of the design variables

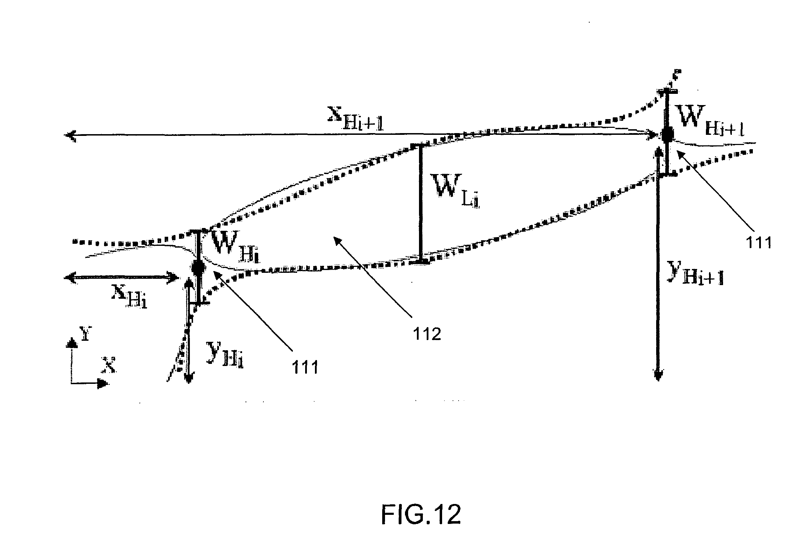

The design variables are allocated to the hinge element 111 and the lump element 112 as being a portion featuring the flexibility and the stiffness. The hinge element 111 has a function generally the same as that of a joint of a conventional mechanism, and deformation concerning the flexibility centering on the hinge element 111 can be controlled by adjusting its features. However, since it is impossible to make the hinge element 111 in a process of actual design, the design variables are arranged along a. width as shown in Fig. 12 so as to obtain a portion that both meets the stress constraint and has sufficient flexibility. In addition, since the location of the hinge element 111 dominates the performance, the location of the hinge element 111 is also set to be the design variable. If the location changes considerably, the topology of the structure also changes. Then only a vicinity of the initial location is changed. In addition, the lump element 112 is considered to be a structure connecting two hinge elements 111 and a width of an intermediate position between the hinge elements 111 is set to be the design variable.

(2) Set of control points and a curve

After the design variables are set, control points of a curve necessary for expressing the initial shape IS are set. As shown in Fig. 12, both ends of the width of the structure set for the hinge element 111 and the lump element 112 are set to be the control points. Adjacent control points are connected so as to be the curve that does not cross. A spline curve is used as the curve. The curve is not limited to a spline curve and may be any curve as far as the curve is an interpolation curve.

<Step Sa4> Set of the design condition of the shape optimization

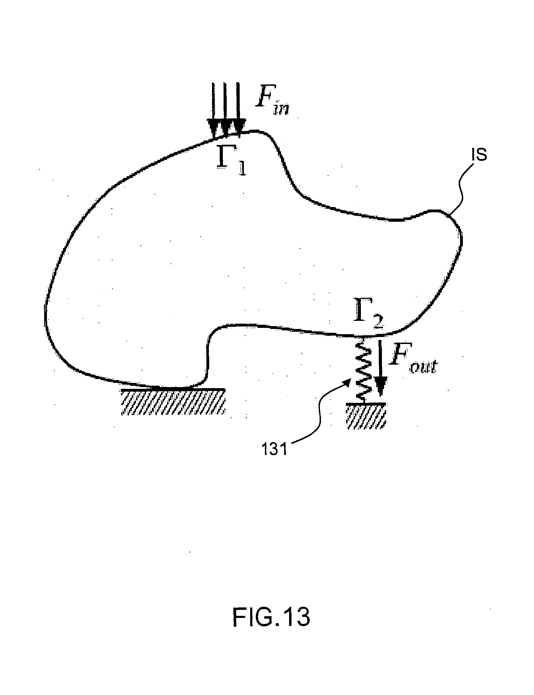

Next, the design condition of the shape optimization is set. Formulation of the optimization problem varies a little depending on application of the compliant mechanism. Physical quantities set by the shape optimization are an amount of displacement and a reaction force load of the boundary $\Gamma_1$ and the boundary $\Gamma_2$, and a stress in the design domain D shown in Fig. 13. Following formulation is carried out for these physical quantities as a representative example.

[Equation 15]

$$\text{maximize } d_{out}$$

Constraint condition

[Equation 16]

$$\sigma_M \leq \sigma_{allow}$$

[Equation 17]

$$F_{in} \leq F_{max}$$

Where $d_{out}$ is a displacement of a direction shown by the dummy load $t^2$ at a portion where a load is applied to an object, $\sigma_M$ is a Mises equivalent stress, $\sigma_{allow}$ is an allowable stress, $F_{in}$ is a reaction force load at the boundary $\Gamma_1$, namely the portion where the load is applied and $F_{max}$ is its upper limit.

A force applied to an object to be acted or an energy applied to an object to be acted is conceived as a physical quantity to be dealt with by the optimization problem. A range of the design variable concerning a shape is also considered as a constraint condition. Furthermore, a spring constant can be arbitrarily set due to a specification of the object to be acted.

In addition, it is necessary to quantitatively evaluate a reaction force of a workpiece that the design domain D receives through the boundary $\Gamma_2$ based on a real phenomenon in order to make a quantitative analysis. As a method for applying this reaction force, as shown in Fig. 13, a practical analysis is made by adding a spring element 131 having a spring constant that has been previously determined by an experiment to the boundary $\Gamma_2$.

<Optimization algorithm>

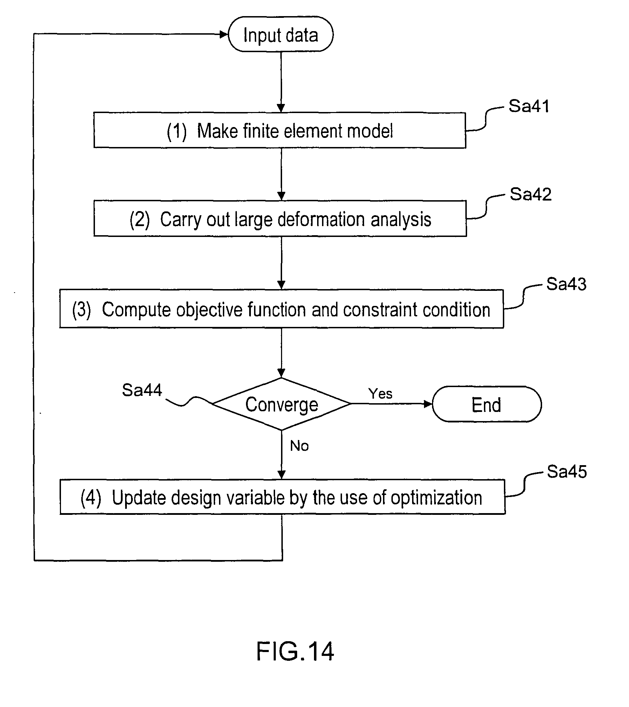

A flow chart of the shape optimization is shown in Fig 14. First, (1) a finite element model is made (step Sa41). Next, (2) a large deformation analysis is carried out (step Sa42). By the use of the analytic solution, (3) the objective function and the constraint condition are computed (step Sa43). Then if the objective function converges, the algorithm terminates (step Sa44), if not, (4) the design variables are updated by the use of the optimization procedure (step Sa45) and the procedure returns to the step Sa41.

<Step Sa5> Design of the optimal shape OS by the use of the shape optimization procedure

The shape optimization is executed based on the initial shape IS made in the step Sa3 and the design condition set in the step Sa4. Since an object of the step Sa5 is to determine a detailed shape of the compliant mechanism by the quantitative evaluation of the displacement amount, the reaction force and the stress, the analysis to obtain these physical quantities has to assess an actual behavior strictly. As a result, in this step Sa5 it is desirable to practice the optimization with carrying out a large deformation nonlinear response analysis.

With the optimal design support system 1 in accordance with this embodiment, it is possible to create the organic coupling structure (structure) FM of multiple different elements featuring the compliant mechanism by the use of the topology optimization procedure and to design the detailed optimal shape OS that can actually be manufactured with taking advantage of the mutually different elements (the hinge element 111 and the lump element 112). As a result of this, it is possible to design a practical compliant mechanism without compelling a designer to conduct trial and error processes in case of setting the initial shape IS of the shape optimization by making use of the hinge element 111 that has been considered to avoid.

Furthermore, since the design variables that can be updated by the shape changing part 13 are arranged respectively for every different element as being a reference to change the shape, the initial shape IS is determined based on the design variables, and the shape changing part 13 changes the initial shape IS by updating the design variables, it is possible to set the initial shape IS with securing the features of each element accurately. Furthermore, it is possible to arrange the design variables more preferably compared with a case that the design variables are arranged arbitrarily, thereby to lessen a number of the design variables. As a result of this, it is possible to lessen time required for changing the initial shape IS.

Next, an application to a clip forceps 2 for medical use as being a concrete embodiment of the present claimed invention will be explained.

(A) A clip forceps for medical use

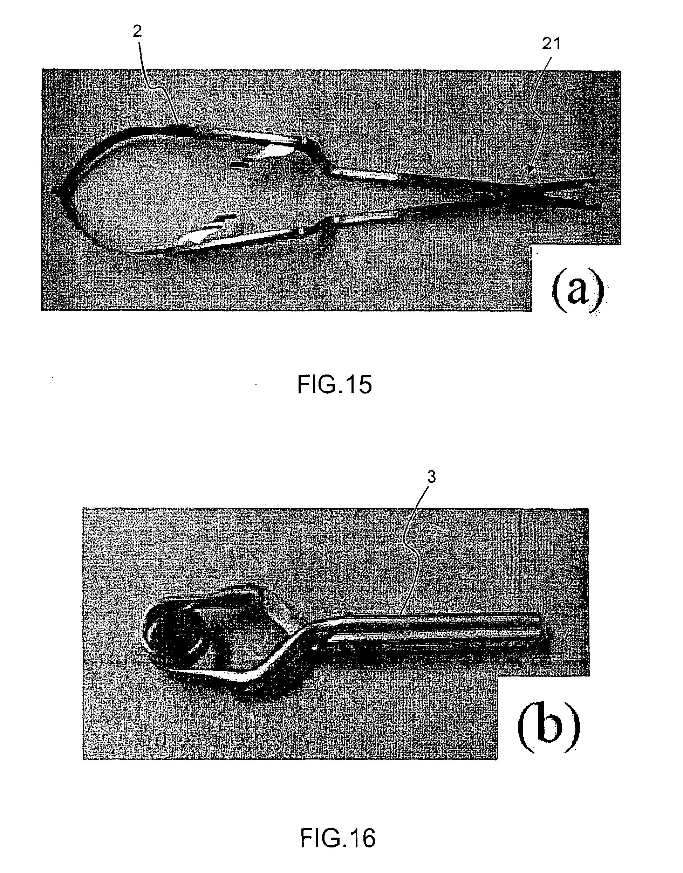

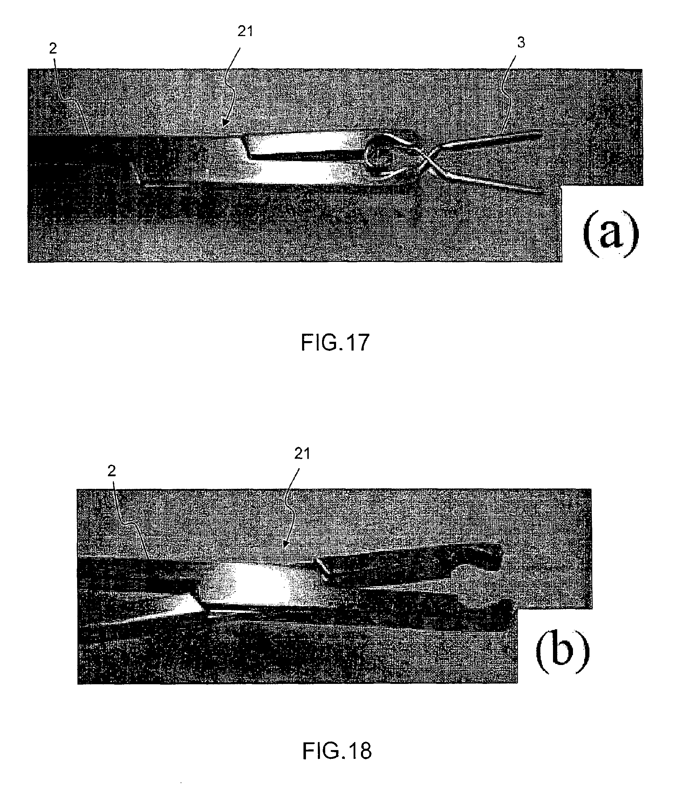

The clip forceps 2 for medical use (hereinafter called as the forceps) is a tool used in case a doctor manipulates a clip 3 that stops bleeding by gripping a blood vessel. The forceps 2 and the clip 3 are shown in Fig. 15 and Fig. 16, and a state that the clip 3 grasped by the forceps 2 is shown in Fig. 17. A material is mainly steel. Problematical points of current forceps is represented by that cleaning is troublesome because blood is fixed on a link part 21 shown in Fig. 18, and that rust is easily formed due to a solvent used for cleaning or attached blood. A former problematical point is resulting from a point that a mechanism uses the joint, and a later problematical point is resulting from a point that the forceps is made of steel. Then this embodiment intends to solve this problem by realizing the forceps with the compliant mechanism of a polymer molecule material. In addition, since integrally molded goods of a polymer molecule material can be manufactured with a very low cost, it is possible to make the forceps of the polymer molecule material not for a repeated use like conventional forceps but for a disposable use. The forceps of this material is thought of as very useful especially for a scene of an emergency medical service where a sufficient support system is unlikely put in place.

In this embodiment, the polymer molecule material is ultrahigh molecular weight polyethylene used for a medical use with the Young's modulus of 720 Mpa, Poisson's ratio of 0.3 and bearing force of 30 MPa. A part including the hinge element 111 and a flexible element is called as a movable part in this embodiment.

(B) Example of design

(B-1) Step Sa1

First, directions of input and output are considered. Since an object of this embodiment is to substitute the forceps 2 of this embodiment for a conventional forceps, directions of input and output are set to grasp the clip 3 with the same manipulation as that of the conventional forceps, namely the clip tip closes when a user applies a suitable input force. In addition, since it is desirable that the shape and the size are also closely related to the conventional forceps, the design domain D is set with using example from the conventional forceps.

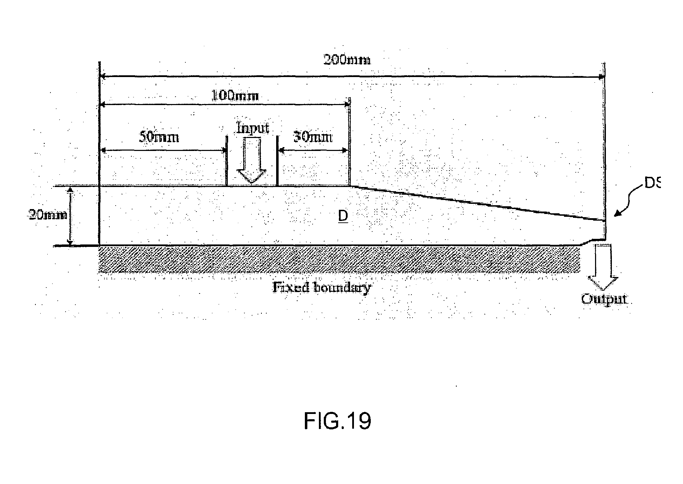

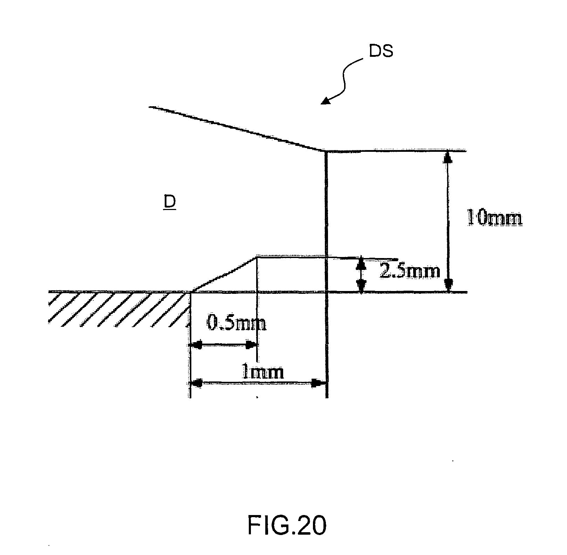

The design domain D, the boundary condition and directions of the input and output of the topology optimization are shown in Fig. 19. An enlarged view of a distal end portion DS of the design domain D is shown in Fig. 20. Since the forceps 2 of this embodiment is assumed to be symmetric along a longitudinal axis, the area for which an optimization is actually conducted is an upper half of the forceps 2. In this embodiment, the design domain D is divided by the use of a four-node isoparametric element and a total number of elements becomes 6061 pieces. A volume constraint is set to be 20% of a total design domain D.

(B-2) Step Sa2

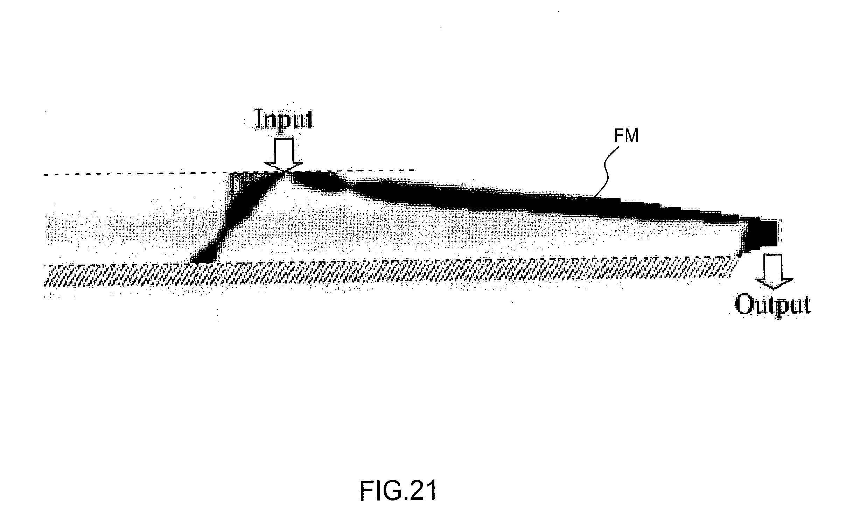

An optimization result of the topology optimization is shown in Fig. 21.

(B-3) Step Sa3

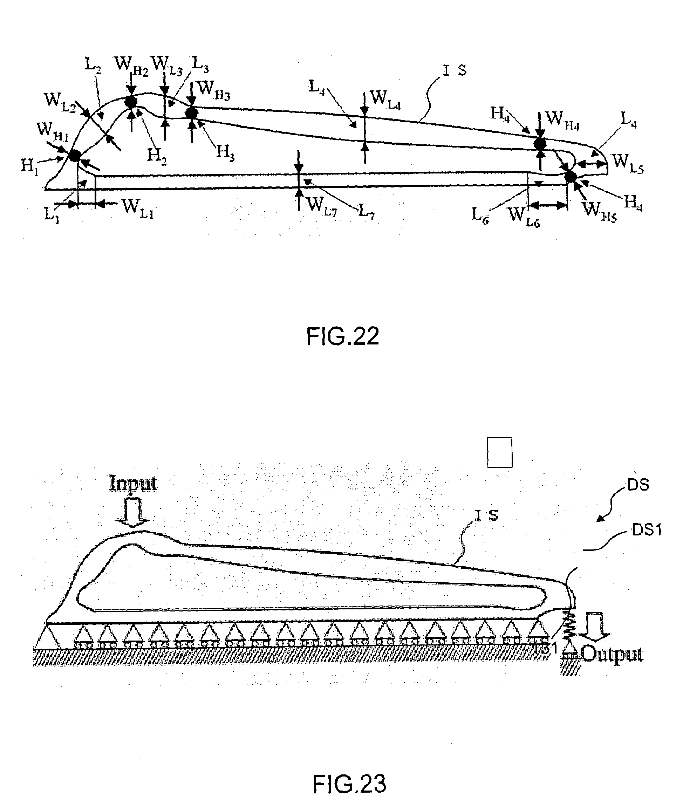

Extraction of the movable part is conducted based on the result obtained by the step Sa2. In this embodiment five movable parts $H_1 \sim H_5$ are arranged as shown in Fig. 22. The location and the width of the movable part can be conceived as the design variables of the movable part, however, the location of the movable part is fixed and only the width of the movable part is set as the design variables in this embodiment. This is because no difference has been noticed in the optimal shape OS between a case that the location of the movable part is optimized and a case that the location of the movable part is fixed. In addition, the design variables are arranged at portions $L_1 \sim L_7$ for the lump element 112. A concrete method for arranging the design variables is to set the widths $W_{H5}$ and $W_{L1} \sim W_{L7}$ of $H_5$ and $L_1 \sim L_7$ as the design variables for $H_5$ and $L_1 \sim L_7$, and to obtain the width $W_{H1} \sim W_{H4}$ of the movable parts by multiplying the widths $W_{L1} \sim W_{L4}$ of each of adjacent lump elements 112 by coefficients $k_1 \sim k_4$ and then to set the coefficients $k_1 \sim k_4$ as the design variables for $H_1 \sim H_4$. Then the initial shape IS of the shape optimization is determined as shown in Fig. 23 by arranging the control points based on these design variables and connecting them with a spline curve.

(B-4) Step Sa4

The displacement $d_{out}$ of an output part DS1 of the distal end portion <u>DS</u> of the forceps 2 is used as the objective function, and the above-mentioned parameter and the displacement $d_{in}$ of the input part are used as the design variables. The maximum corresponding stress $\sigma_{max} \leqq 30$ MPa and the input part reaction force $F_{in} \leqq 50$N are used as the constraint condition. A spring element 131 with a spring constant of $3.0 \times 10^4$N/m is arranged for the output part DS1 in order to express the reaction force of the clip 3.

(B-5) Step Sa5

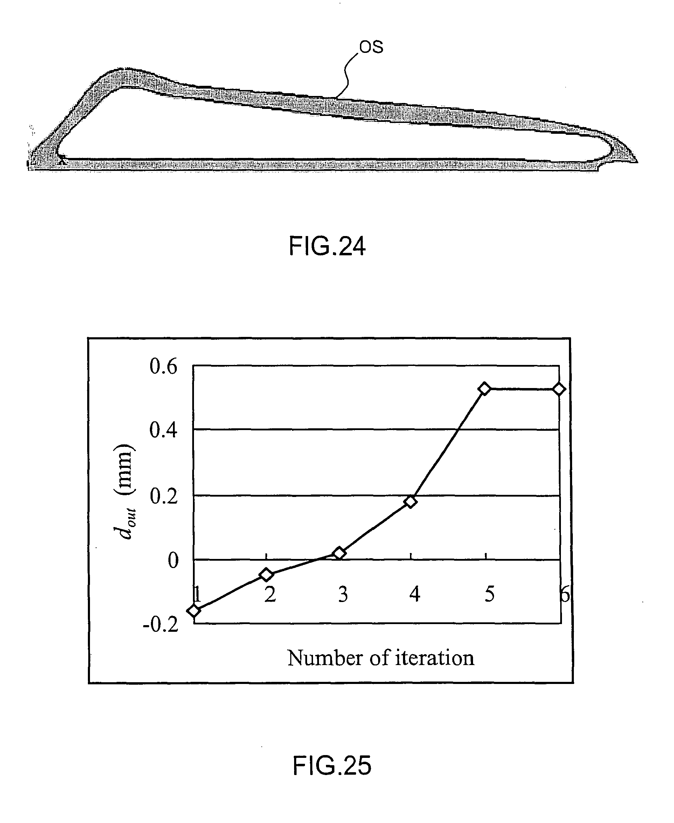

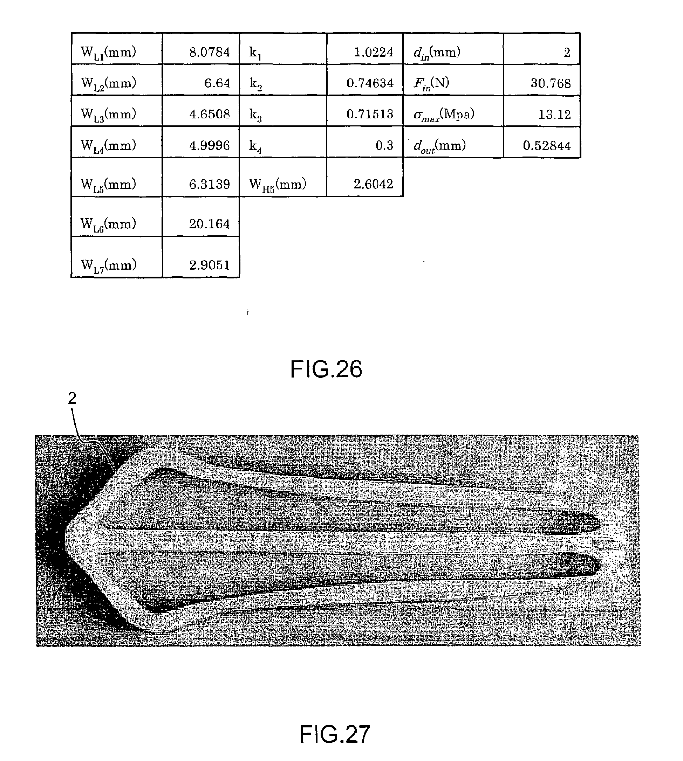

The shape optimization is conducted by the use of the initial shape <u>IS</u> and the design condition made in the steps Sa3 and Sa4. The optimal shape <u>OS</u> is shown in Fig. 24, and a value of a final objective function, values of each design variable and each constraint condition are shown in Fig. 26. Fig. 25 is a graph wherein a number of iterations of optimization is shown on an x-axis, and a downward displacement $d_{out}$ at the distal end <u>DS</u> of the forceps 2 as being the objective function is shown on an y-axis.

(C) Experimental production

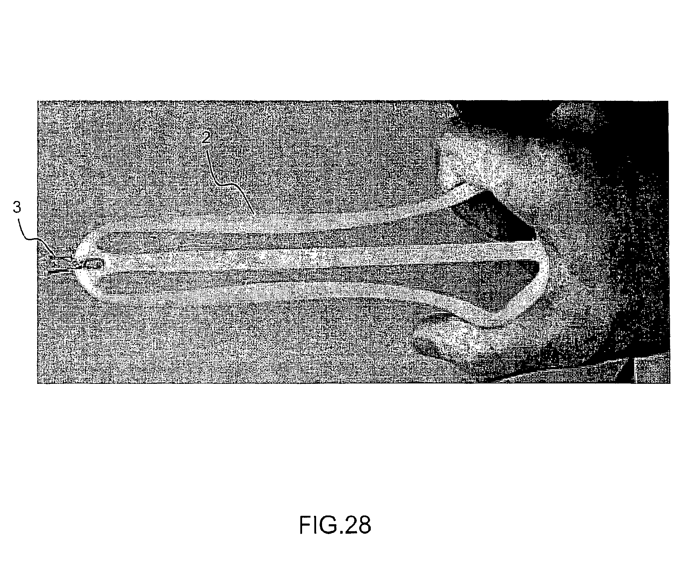

An experimental production of the forceps 2 is conducted based on the obtained optimal shape <u>OS</u>. For this experimental production, a plate of ultrahigh molecular weight polyethylene with a thickness of 10 mm is used and a cutting procedure is conducted in a machining center. Fig. 27 shows a manufactured prototype of the forceps 2 and Fig. 28 shows a state that the clip 3 is actually grasped by the manufactured prototype of the forceps 2. The manufactured prototype of the forceps 2 shows that the compliant mechanism created by this embodiment acts accurately.

<A second embodiment>

A second embodiment in accordance with this invention will be explained with reference to drawings. The same numerical code is given to the same component corresponding to the above-mentioned first embodiment.

The optimal design support system 1 in accordance with this embodiment is to make a design concept <u>DC</u> by combining a compliant mechanism created by a topology optimization and an additional mechanism created by a designer, to set an initial shape <u>IS</u> based on the design concept <u>DC</u> and then to conduct a shape optimization. The optimal design support system 1 further comprises a nonlinear structural data storing part D6 and the initial shape setting part 12 is different from the above-mentioned first embodiment.

The nonlinear structural data storing part D6 stores nonlinear structural data of a nonlinear structure <u>NS</u> showing a nonlinear modification behavior that has been previously input by the designer. The nonlinear structure <u>NS</u> is created by the designer himself or herself based on his or her experiment, knowledge or idea and is stored in the nonlinear structural data storing part D6 by the use of a input means 103. Since a detailed concrete shape of the nonlinear structure <u>NS</u> is determined by conducting a second stage shape optimization, to be described later, a general shape may be created in a first stage based on an approach what kind of mechanism is given. Here the nonlinear structure <u>NS</u> is a structure that is impossible or difficult for the functional creating part 11 to create, and for example, a buckling structure that makes a buckling deformation or a structure having a ratchet mechanism.

The initial shape setting part 12 produces the design concept <u>DC</u> combined by an optimal structure <u>FM</u> created by the structure creating part 11 and the nonlinear structure <u>NS</u> that has been previously set by the designer and sets the initial shape <u>IS</u> that can be realized so as to secure its property for each element of the design concept <u>DC</u>. A method for setting the initial shape <u>IS</u> is the same as that of the first embodiment.

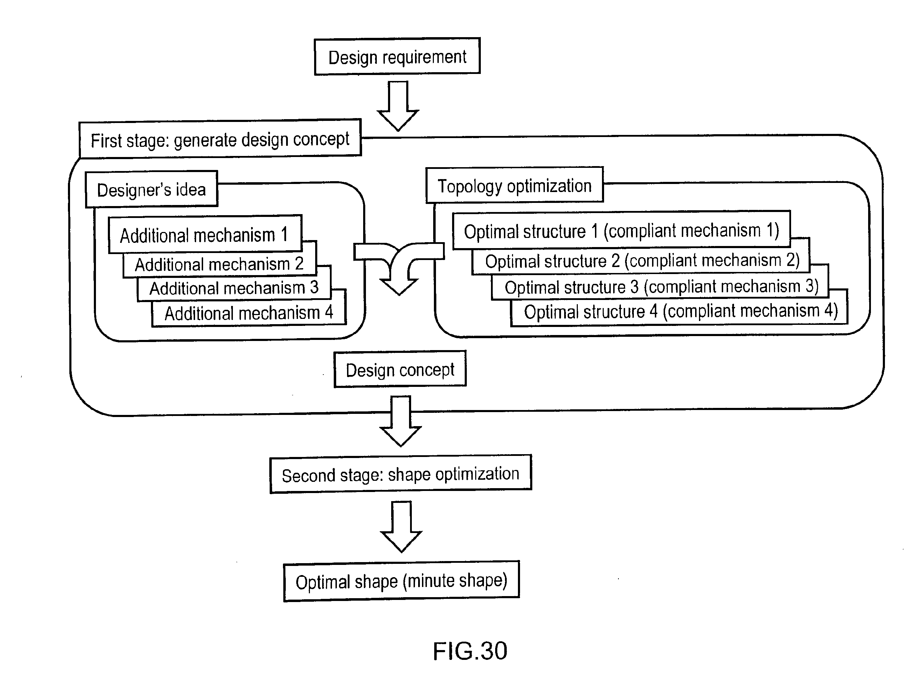

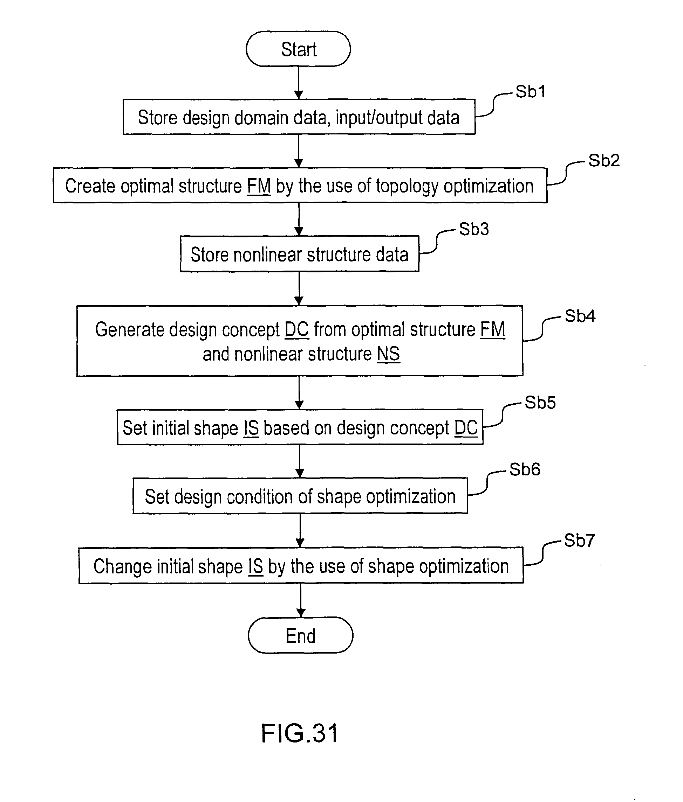

Next, a performance of the optimal design support system 1 of the above arrangement will be explained with reference to Fig. 30 and Fig. 31.

The optimal design support system 1 in accordance with this embodiment comprises, as shown in Fig. 30, the first stage and the second stage. The first stage creates the optimal structure <u>FM</u> in accordance with the compliant mechanism and the nonlinear structure <u>NS</u> as being an additional mechanism by the use of the topology optimization and an idea generation support procedure and makes the design concept <u>DC</u> of good birth by combining the optimal structure <u>FM</u> and the nonlinear structure <u>NS</u>. The second stage sets the initial shape <u>IS</u> based on the design concept <u>DC</u> and conducts the shape optimization so that the optimal shape that considers a quantitative performance and an engineering requirement such as a stress concentration is obtained. Detail will be described as follows.

(1) First stage

First, an operator manipulates the input device 103 in order to input a design domain data, an input and output data, a boundary data and an analysis data.

Each data input by the above process is received by a data receiving part (not shown in drawings), and the design domain data is stored in a design domain data storing part D1, the input and output data is stored in an input and output data storing part D2, the boundary data is stored in a boundary data storing part D3, and the analysis data is stored in an analysis data storing part D4 (step Sb1).

Next, the structure creating part 11 creates the optimal structure FM by the use of the topology optimization procedure (step Sb2).

Then the designer creates the nonlinear structure NS to be added to the optimal structure FM created in the step Sb2 by the use of the idea generation support procedure, to be described later, and stores the nonlinear structure NS in the nonlinear structure data storing part D6 by the use of the input device 103 (step Sb3).

Later, the initial shape setting part 12 produces the design concept DC by combining the optimal structure FM created by the structure creating part 11 and the nonlinear structure NS (step Sb4).

(2) Second stage

Then, the initial shape setting part 12 sets the initial shape IS of the shape optimization from the design concept DC (step Sb5).

Next, the operator manipulates the input device 103 so as to input a quantitative design condition in the shape changing part 13.

The design condition input by the operator is received by the data receiving part (not shown in drawings) and stored in the real design data storing part D5 (Step Sb6). The design condition may be previously stored in the real design data storing part D5.

Then the shape changing part 13 changes the initial shape IS by the use of the shape optimization procedure and obtains the optimal shape OS (step Sb7).

Making the design concept DC by the use of the idea generation support procedure will be described as follows.

(A) Establishment of the idea generation support procedure

A series of processes to make the design concept DC can be visualized from two standpoints; (A-1) a flow of a detailed thinking of the designer, and (A-2) a relationship between a design object and an obtained idea. Following is a method for visualization based on the two standpoints.

(A-1) Flow of the detailed thinking of the designer

The action of the designer during a creative action can be generally divided into two actions; thinking and study of the idea. When defining two actions, the flow of the designer's thinking can be expressed as an assembly of a flow consisting of a thinking of an idea and a series of a study of the idea resulting from the idea. With this procedure, a flow is called as a session, and considered to be a basic unit of the creative action. An action to be a trigger of a session is called as a trigger action and a series of actions caused by the trigger action is called as a response action. The trigger action is an action to be a starting point of the session such as a presentation of an idea or a topic to be studied in the response action, and the response action is an action to be conducted to the trigger action or other response action such as a study of an idea, a study of a topic presented by the trigger action, or presentation of the idea newly obtained in a process of the session.

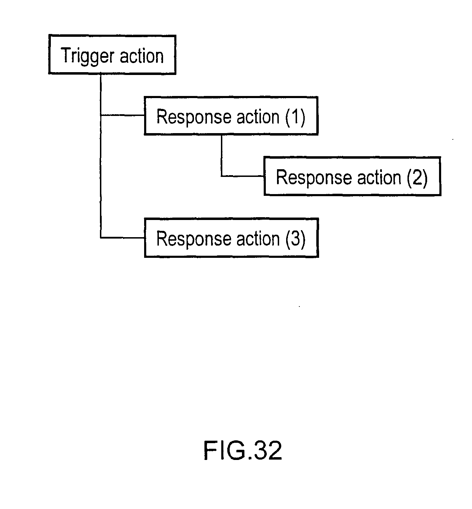

Since the response action can be conducted freely to the trigger action or other response action, the session can be visualized as a tree structure like Fig. 32. As a result, a flow of thinking by the designer during the creative action can be visualized as an assembly of the tree structures of the sessions.

(A-2) Relationship between the design goal and the idea

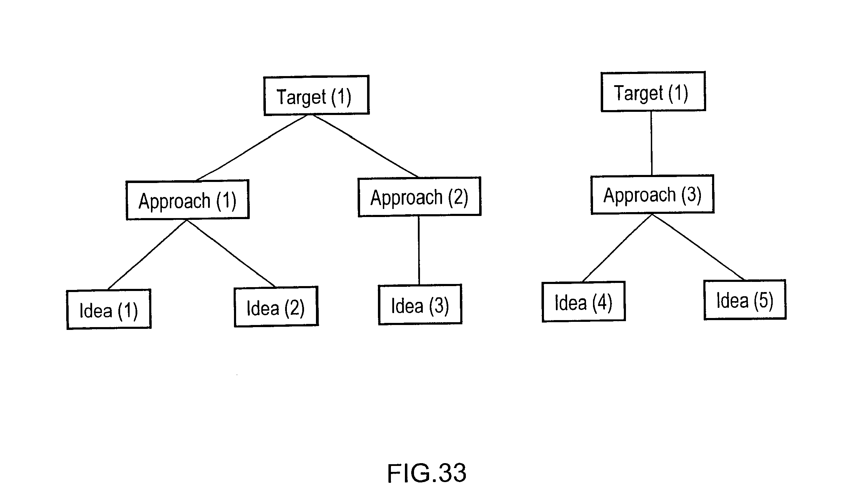

Generally, in case of seeking a new idea with pursuing a solution of a problem or an attainment of a goal, first an orientation to solve a problem or to attain an object is considered, and then an idea is embodied based on the orientation. The orientation to attain the goal is defined as an approach. The relationship between the goal and the idea can be modeled as a hierarchical structure of three hierarchies; the goal, the approach and the idea as shown in Fig. 33 by defining the approach. Then a process to consider the orientation, namely the approach is conducted demonstratively by the use of the hierarchical structure and the idea is embodied based on the approach. This makes it possible to search greater variations of broad ideas.

In this embodiment, the hierarchical structure is made by setting a function that the designer wants to provide a product as the goal, a concept of a mechanism to realize the function as the approach and the mechanism embodied based on the approach as the idea. The mechanism created in this embodiment can be classified into a compliant mechanism and other portion or function, and a relationship between the design domain and the input and output is set as the approach for the compliant mechanism and a principle of an operation at the other portion is set as the approach for the other portion. In case of embodying the mechanism from the approach, the topology optimization is executed for the compliant mechanism and the other mechanism is embodied based on the creativity of the designer. Each method for embodiment will be described later.

(B) Creation of the high function/high performance compliant mechanism

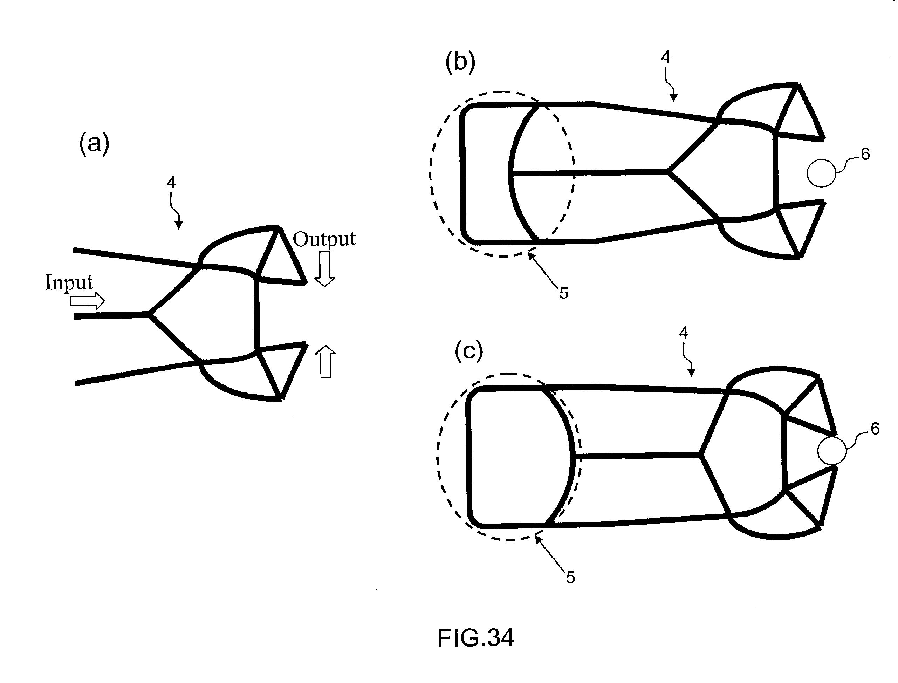

Next, what type of the design concept DC is made by the use of the mechanism created by the idea generation support procedure will be described. In this specification, it is conceived that a mechanism having an additional function is combined with the compliant mechanism. As a result of this, it is possible to realize the high function/high performance compliant mechanism that can not be designed only by an optimal design of multiple stages. As an example, a gripper 4 to which a stopper mechanism 5 is given is quoted as shown in Fig. 34. In accordance with this example, it is possible to continue gripping a workpiece 6 without continuously applying an external force when the gripper 4 grips the workpiece 6 by giving the stopper mechanism 5 that makes use of a buckling phenomenon to the gripper 4 based on the compliant mechanism shown in Fig. 34 (a) (refer to Fig. 34 (b) (c)).

(B-1) Procedures of making the design concept DC

Finally, a procedure for making the design concept DC by the use of the idea generation support procedure will be described. This procedure consists of two steps.

(B-1-1) Step 1: Making of a hierarchical structure drawing

The designer writes the approach or the idea on the link structure drawing and creates the hierarchical structure drawing with recording a flow of the creative action as the session.

(B-1-2) Step 2: Making and evaluation of the design concept DC

The design concept DC is made and evaluated by combining the mechanisms obtained in the step 1. In case that the design concept DC that satisfies the designer is obtained, the first stage is terminated and the procedure proceeds to the second stage. In case that the design concept DC that does not satisfy the designer is obtained, the procedure returns to the step 1 after analyzing a problematical point of the design concept DC and then a new mechanism is created and a trial is made to create a new design concept DC. In a stage of making and evaluating the design concept DC, a series of the process is visualized by the use of the session. As a result of this, a process of examination or improvement can be cleared up, resulting in helping seek a better design concept DC.
With the optimal design support system 1 in accordance with this embodiment, it is possible to design the compliant mechanism of high function and high performance beyond a conventional optimization.

(C) Design example

A gripper 4 with a stopper 5 as being a concrete example of this embodiment will be explained as follows.
The gripper 4 with the stopper 5 in accordance with this embodiment is the gripper 4 to which a stopper function is given. A relationship between the input and the output is so set that the distal end portion 41 of the gripper 4 closes in case that a user applies a force to the gripper 4 and the location and the direction of the input can be arbitrarily determined. The stopper 5 acts when the user applies the force to the gripper 4 and fixes the gripper 4 in a closed state. The material of the gripper 4 with the stopper 5 is ultrahigh molecular weight polyethylene with a thickness of 5 mm, a Young's modulus of 720 Mpa, and Poisson's ratio of 0.3. In this embodiment, the movable part includes the hinge element 111 and the flexible element.

(1) First stage

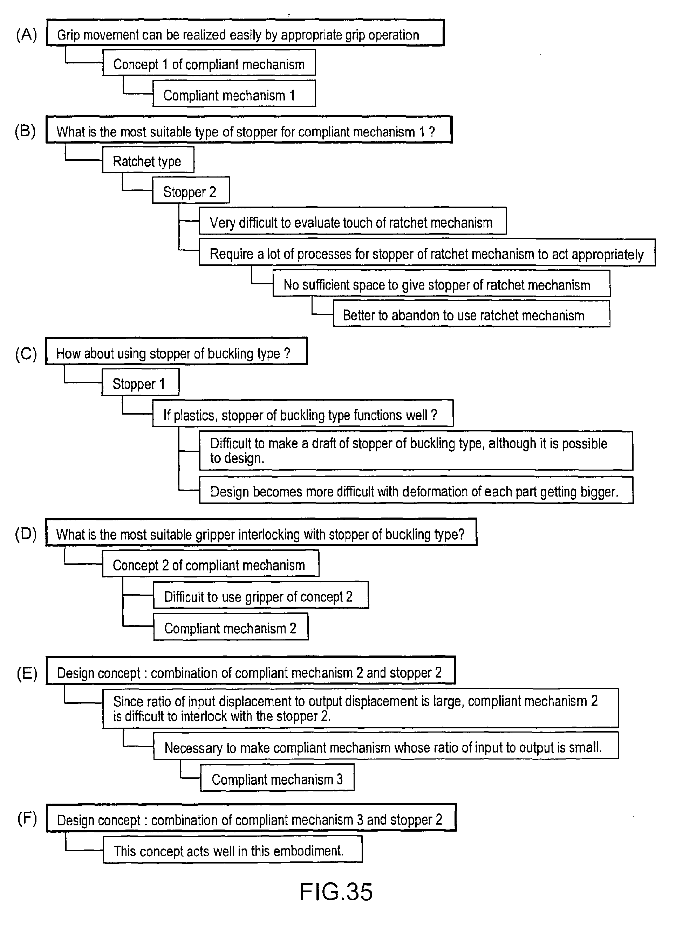

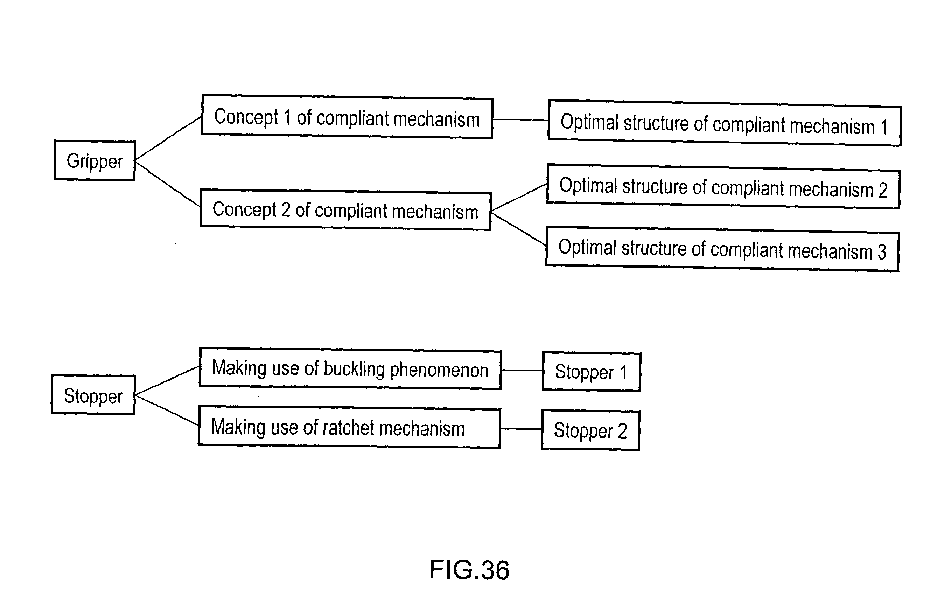

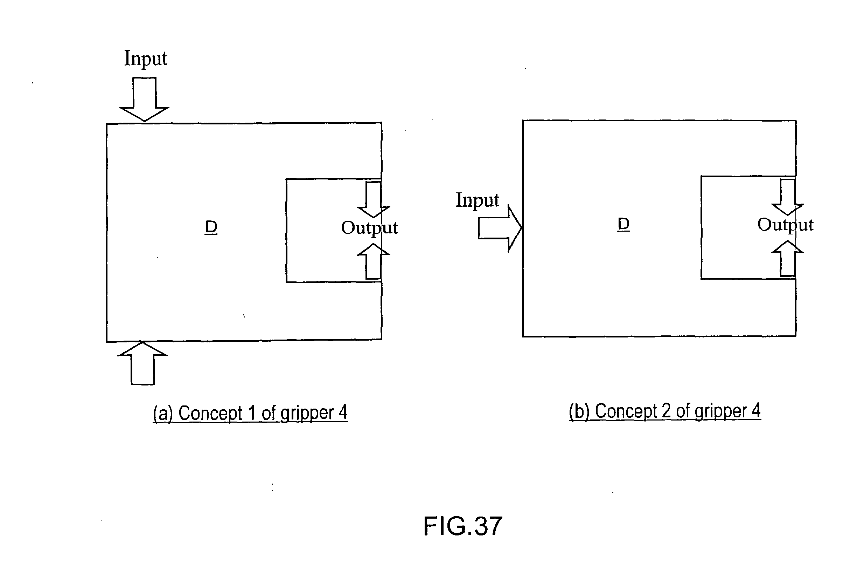

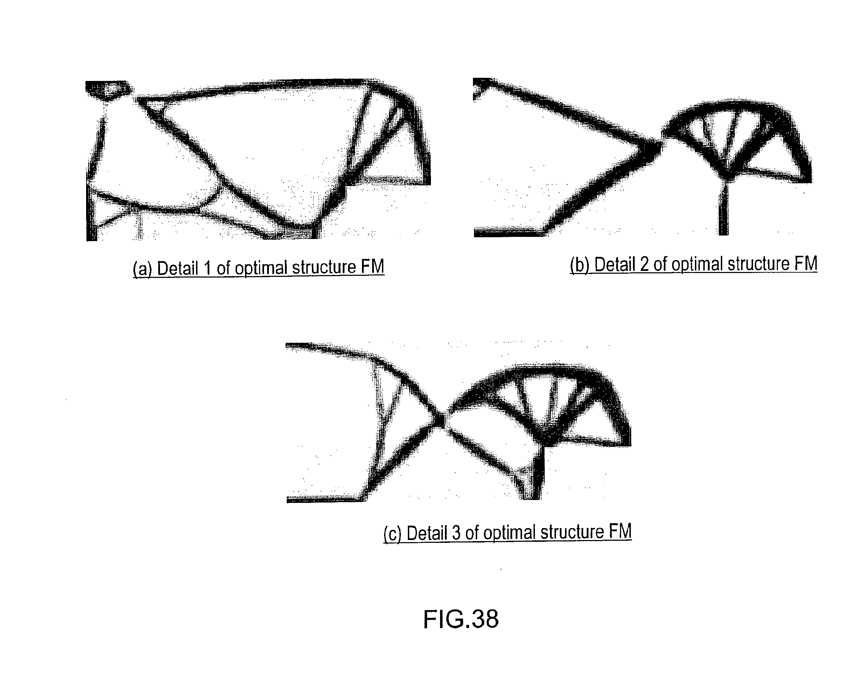

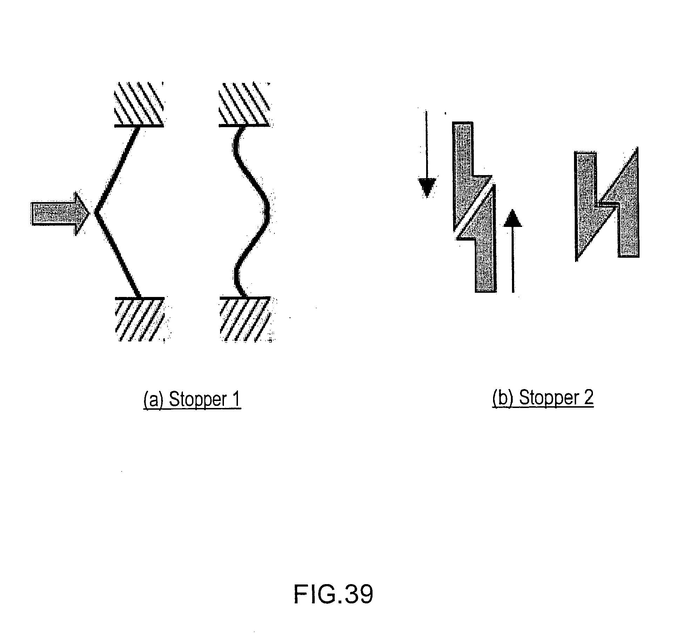

In the first stage, the design concept DC of the gripper 4 with the stopper 5 is produced by the use of the idea generation support procedure.
A flow of the first stage visualized by the use of the session is shown in Fig. 35 and the created hierarchical structure drawing is shown in Fig. 36. A detailed concept 1 of the gripper 4 as being the compliant mechanism is shown in Fig. 37(a), a detailed concept 2 of the gripper 4 is shown in Fig. 37(b), details 1, 2, 3 of the optimal structure FM of the gripper 4 obtained by the topology optimization are shown in Fig. 38(a) - (c), and details 1, 2 of the stopper 5 are shown in Fig. 39(a) (b). The compliant mechanism is assumed to be symmetric along a longitudinal axis, the design domain is an upper half of the compliant mechanism and then the optimal structure $\underline{FM}$ was created by the topology optimization.

Next, as a result of considering various factors as shown in Fig. 35, in order to make the design concept $\underline{DC}$, this embodiment adopts the design concept $\underline{DC}$ that is combined with the stopper 5 making use of the compliant mechanism and the buckling shown in a detail 3 of the gripper 4 of Fig. 38 (c).

(2) Second stage

The initial shape $\underline{IS}$ is set and the shape optimization is conducted based on the design concept $\underline{DC}$ made in the first stage.

(2-a) Making of the initial shape $\underline{IS}$

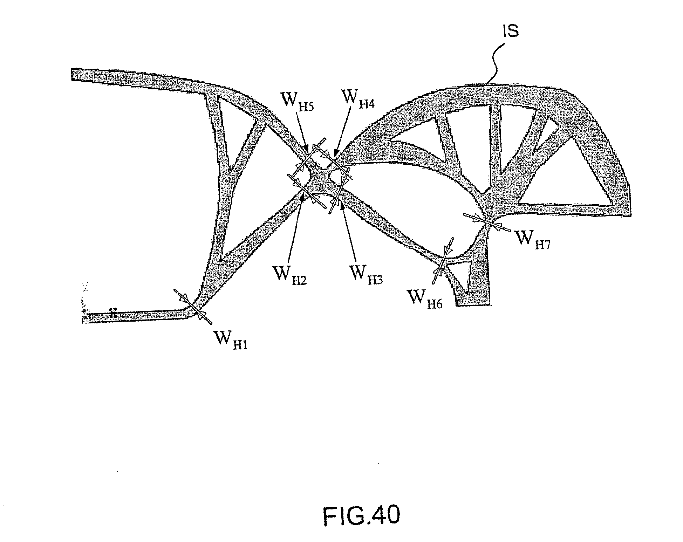

For the gripper 4, the design variables are arranged at seven movable portions $H_1 \sim H_7$ shown in Fig. 40. A location and a width of each movable portion can be used as the design variables of the movable portion. In this embodiment, however, the location and the width of the movable portion are controlled at once by setting the locations of the two control points arranged at each movable portion as the design variables. For the lump elements 112, in order to reduce a calculation amount of the optimization and to conduct a stable optimization, its width is made to be a fixed value. Then the control points are arranged based on the design variables, and the initial shape $\underline{IS}$ is set by connecting with the spline curve.

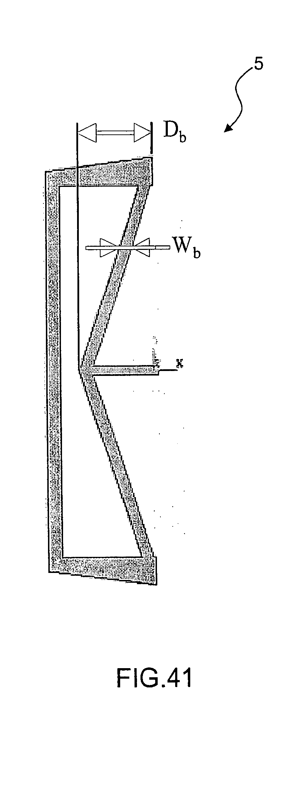

For the stopper 5, as shown in Fig. 41, the stopper 5 is considered to be of a "V" character type, and a depth $D_b$ and a width $W_b$ of a "V" character portion are set to be the design variables. For a width of a frame locating outside, the width of the frame is set to be a fixed value instead of the design variables in order to provide a sufficient thickness. Then the initial shape $\underline{IS}$ of the stopper 5 is set by combining a straight line and a curve based on these design variables.

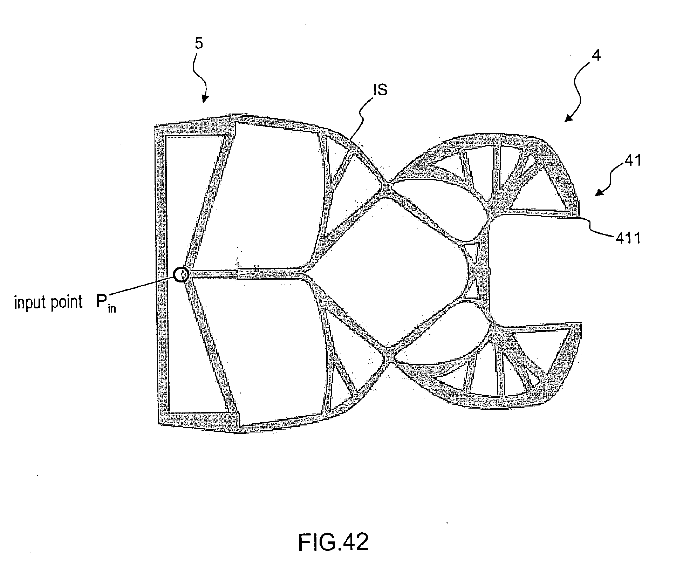

Fig. 42 shows an overall model wherein a model of the gripper 4 is combined with a model of the stopper 5. The shape optimization of conducted by the use of this initial shape $\underline{IS.}$

(2-b) Setting of the design condition

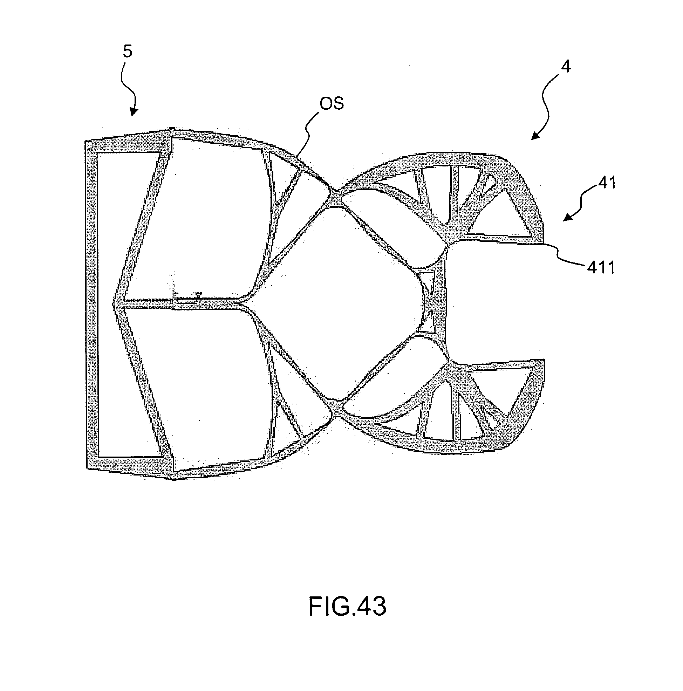

A displacement $d_{out}$ at an output part 411 of a distal end 41 of the gripper 4 is used as the objective function, and a parameter set in (2-a) is used as the design variables. As a matter of convenience for making an analysis, it is so set that there is a state where a reaction force $F_{in}$ generating at an input point Pin shown in Fig. 43 becomes less than or equal to 0 N. The state where the reaction force $F_{in}$ becomes 0 N shows that a force generating from a buckling equilibrates the reaction force from the gripper 4 and this state is kept without any input from outside.

(2-c) Shape optimization

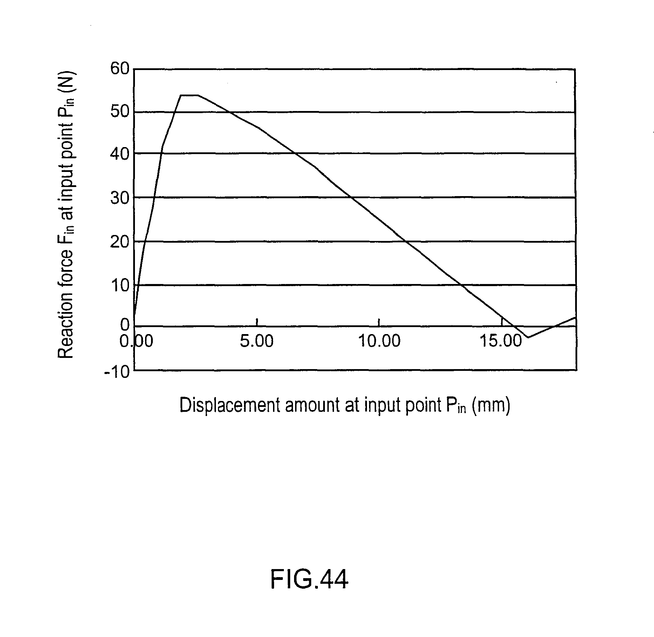

A shape optimization is conducted based on the initial shape $\underline{IS}$ and the design condition. An optimal shape is shown in Fig. 43, and a graph expressing a relationship between the displacement amount at the input point $P_{in}$ and the reaction force $F_{in}$ is shown in Fig. 44. It is turned out that each of seven movable parts $H_1 \sim H_7$ becomes of a thin shape and more flexible if comparison is made between the initial shape $\underline{IS}$ shown in Fig. 42 and the optimal shape shown in Fig. 43. It is also turned out from Fig. 44 that the reaction force $F_{in}$ = 1.95 N at a time when the displacement amount at the input point Pin is 16.2 mm, which means that the stopper 5 functions well. In addition, finally the objective function $d_{in}$ = 6.18 mm and the maximum corresponding stress $\sigma_M$ = 54.9 MPa.

<Other embodiment>

The present claimed invention is not limited to the above-mentioned embodiments.

For example, in the first and the second embodiments, the initial shape $\underline{IS}$ is set by arranging the design variables on the hinge elements and the lump elements, setting both ends of the design variables as the control points and connecting the control points with the interpolation curve, however, a method for setting the initial shape $\underline{IS}$ is not limited to this. The initial shape may be set by creating an outer shape by the use of a level set method from an optimal structure obtained by the topology optimization. And the design variables may be arranged at portions corresponding to the hinge elements and the lump elements of this initial shape. With this arrangement, it is possible to automatically set the initial shape $\underline{IS.}$

In addition, with the above-mentioned second embodiment, the initial shape $\underline{IS}$ is created by combining the

nonlinear structure <u>NS</u> created by the idea of the designer and the compliant mechanism in the initial shape setting part 12, however, it is not limited to this and the initial shape may be set by combining multiple structures created by the structure crating part. In addition, the initial shape may be set by combining multiple structures and a nonlinear structure based on the idea of the designer.

In accordance with this arrangement, it is possible to provide each portion with the optimal features. In addition, it is also possible to design a compliant mechanism comprising multiple components, which enables to change a material for each component and to provide multiple functions by exchanging a component if required.

Furthermore, in the above-mentioned second embodiment, the nonlinear structural data is stored in the nonlinear structure data storing part after creating the optimal structure during the operation of the optimal design support system, however, it is not limited to this and the nonlinear structural data may be previously determined and then stored.

A part or all of each embodiment or the modified embodiment may be combined arbitrarily, the present claimed invention is not limited to each of the above-mentioned embodiments, and there may be various modifications without departing from a spirit of the present claimed invention.

**POSSIBLE APPLICATIONS IN INDUSTRY**

As mentioned above, since it is possible for the optimal design support system in accordance with the present claimed invention to create the integrated structure of multiple mutually different types of elements that feature the compliant mechanism and then to design the detailed shape that can actually be manufactured by making the most use of the mutually different types of elements, the optimal design support system can be preferably used for designing a practical compliant mechanism by making use of the hinge structure that has been considered to be avoided without compelling a designer to conduct trial and error processes when designing the initial shape of the shape optimization.

**Claims**

1.  An optimal design support system for designing an object that outputs a desired load or displacement to a portion by using elastic deformation when a load or displacement is applied to a predetermined portion, comprising:

    a design domain data storing part that stores a design domain data which is a data to set a design domain of the object and an initial material layout within the design domain,
    a structure creating part that changes the material layout within the design domain and creates a structure which is an integrated structure of multiple mutually different types of elements so as to minimize the difference between the output load or displacement and the desired load or displacement and maximize the stiffness of the object globally, the structure having a specified function, the elements representing a specified function;
    an initial shape setting part that sets a feasible initial shape corresponding to the function of each element which forms the structure; and
    a shape changing part that changes the initial shape so as to minimize the difference between the load, the displacement, a related stress, or a related strain and a predetermined target value within a range where any parts of the initial shape deform elastically.

2.  The optimal design support system according to claim 1, further comprising:

    a nonlinear structure data storing part that stores a data showing a nonlinear structure which behaves to deform nonlinearly and which can not be created by the structure creating part, wherein
    the initial shape setting part sets the initial shape by combining the structure and the nonlinear structure.

3.  The optimal design support system according to claim 1, wherein
    the initial shape setting part sets the initial shape by combining multiple structures created by the structure creating part.

4.  The optimal design support system according to claim 1, wherein
    the initial shape setting part sets mutually different design variables as a reference to change a shape on the mutually different types of the elements respectively and sets the initial shape based on the design variables, and
    the shape changing part changes the initial shape by updating the design variables.

5.  The optimal design support system according to claim 1, wherein
    the structure creating part creates the structure by using a topology optimization procedure.

6. The optimal design support system according to claim 1, wherein
the shape changing part changes the initial shape by using a shape optimization procedure.

7. The optimal design support system according to claim 1, wherein
the structure creating part creates two kinds of elements as said elements; one is a hinge element whose stiffness is approximately zero and the other is a lump element which is other potions of the hinge element.

8. The optimal design support system according to claim 7, wherein
the initial shape setting part sets a design variable in a width direction of the hinge element in the structure, sets a width at a predetermined location of the lump element as another design variable, sets a control point based on both of the design variables, and sets the initial shape based on the control point.

9. The optimal design support system according to claim 8, wherein
the initial shape setting part sets a location of the control point as another design variable.

10. The optimal design support system according to claim 7, wherein
the structure creating part further creates a flexible element which is a portion having smaller stiffness than predetermined stiffness in the lump element as said element.

11. The optimal design support system according to claim 10, wherein
the initial shape setting part sets a design variable in a width direction of the hinge element in the structure, sets a width at a predetermined location of the lump element and the flexible element as another design variable, sets a control point based on both of the design variables, and sets the initial shape by using the control point.

12. An optimal design support method for designing an object that outputs a desired load or displacement to a portion by using elastic deformation when a load or displacement is applied to a predetermined portion, comprising:

 a design domain setting step where set a design domain of the object and an initial material layout within the design domain are set;
 a structure creating step where the material layout within the design domain is changed and a structure which is an integrated structure of multiple mutually different types of elements is created so as to minimize the difference between the output load or displacement and the desired load or displacement and maximize the stiffness of the object globally, the structure having a specified function , the elements representing a specified function;
 an initial shape setting step where a feasible initial shape is set corresponding to the function of each element which forms the structure; and
 a shape changing step where the initial shape is changed so as to minimize the difference between the load, the displacement, a related stress, or a related strain and a target value within a range where any parts of the initial shape deform elastically.

13. An optimal design support program for designing an object that outputs a desired load or displacement to a portion by using elastic deformation when a load or displacement is applied to a predetermined portion, wherein functions are provided with a computer, the functions comprising:

 a design domain data storing part that stores a design domain data which is a data to set a design domain of the object and an initial material layout within the design domain;
 a structure creating part that changes the material layout within the design domain and creates a structure which is an integrated structure of multiple mutually different types of elements so as to minimize the difference between the output load or displacement and the desired load or displacement and maximize the stiffness of the object globally, the structure having a specified function, the elements representing a specified function;
 an initial shape setting part that sets a feasible initial shape corresponding to the function of each element which forms the structure; and
 a shape changing part that changes the initial shape so as to minimize the difference between the load, the displacement, a related stress, or a related strain and a predetermined target value within a range where any parts of the initial shape deform elastically.

FIG.1

FIG.2

Start

Store design domain data and input/output data — Sa1

Create structure FM by the use of topology optimization procedure — Sa2

Set initial shape IS from structure FM — Sa3

Set design condition of shape optimization — Sa4

Change initial shape IS by the use of shape optimization procedure — Sa5

End

FIG.3

FIG.4

FIG.5

FIG.6

FIG.7

$t^3$

$\Gamma_1$

$\Gamma_2$

$\Omega_d$

$\Gamma_d$

FIG.8

FIG.9

Input data

(1) Calculate homogenized elastic tensor — Sa21

(2) Solve equilibrium equation — Sa22

(3) Obtain mutual mean compliance, mean compliance, total cubic volume and objective function — Sa23

Sa24 — Converge — Yes — End

No

(4) Compute sensitivities of mutual mean compliance, mean compliance, total cubic volume and objective function — Sa25

(5) Update design variable by the use of sequential linear programming (SLP) — Sa26

FIG.10

FIG.11

FIG.12

EP 1 783 643 A1

$$F_{in}$$

$$\Gamma_1$$

IS

$$\Gamma_2$$

$$F_{out}$$

131

FIG.13

FIG.14

FIG.15

FIG.16

FIG.17

FIG.18

FIG.19

DS

D

10mm

2.5mm

0.5mm

1mm

FIG.20

FIG.21

FIG.22

FIG.23

FIG.24

FIG.25

| $W_{L1}$(mm) | 8.0784 | $k_1$ | 1.0224 | $d_{in}$(mm) | 2 |
|---|---|---|---|---|---|
| $W_{L2}$(mm) | 6.64 | $k_2$ | 0.74634 | $F_{in}$(N) | 30.768 |
| $W_{L3}$(mm) | 4.6508 | $k_3$ | 0.71513 | $\sigma_{max}$(Mpa) | 13.12 |
| $W_{L4}$(mm) | 4.9996 | $k_4$ | 0.3 | $d_{out}$(mm) | 0.52844 |
| $W_{L5}$(mm) | 6.3139 | $W_{H5}$(mm) | 2.6042 | | |
| $W_{L6}$(mm) | 20.164 | | | | |
| $W_{L7}$(mm) | 2.9051 | | | | |

FIG.26

FIG.27

FIG.28

D1    D3    D2    D4

```
┌──────────────┐  ┌──────────────┐   ┌──────────────┐  ┌──────────────┐
│ Design domain│  │ Boundary data│   │Input/output  │  │ Analysis data│
│ data storing │  │ storing part │   │data storing  │  │ storing part │
│ part         │  │              │   │part          │  │              │
└──────────────┘  └──────────────┘   └──────────────┘  └──────────────┘
```

Boundary data

Design domain data    Input/output data    Analysis data

D6

```
┌──────────────┐
│ Nonlinear    │
│ structure    │
│ data storing │
│ part         │
└──────────────┘
```

11

```
┌────────────────────────────────┐
│      Structure creating part    │
└────────────────────────────────┘
```

Nonlinear structure data    Optimal structure data

12

```
┌────────────────────────────────┐
│     Initial shape setting part  │
└────────────────────────────────┘
```

Initial shape data

D5

```
┌──────────────┐
│ Design data  │
│ storing part │
└──────────────┘
```

13

Design data

```
┌────────────────────────────────┐
│       Shape changing part       │
└────────────────────────────────┘
```

Optimal shape data

Optimal structure data

14

```
┌────────────────────────────────┐
│  Calculation result outputting part │
└────────────────────────────────┘
```

1

Calculation result data

FIG.29

FIG.30

Start

Store design domain data, input/output data — Sb1

Create optimal structure FM by the use of topology optimization — Sb2

Store nonlinear structure data — Sb3

Generate design concept DC from optimal structure FM and nonlinear structure NS — Sb4

Set initial shape IS based on design concept DC — Sb5

Set design condition of shape optimization — Sb6

Change initial shape IS by the use of shape optimization — Sb7

End

FIG.31

```
┌──────────────────┐
│  Trigger action  │
└──────────────────┘
   │
   │    ┌──────────────────────┐
   ├────│  Response action (1) │
   │    └──────────────────────┘
   │          │
   │          │    ┌──────────────────────┐
   │          └────│  Response action (2) │
   │               └──────────────────────┘
   │
   │    ┌──────────────────────┐
   └────│  Response action (3) │
        └──────────────────────┘
```

# FIG.32

FIG.33

(a)

4

Input

Output

(b)

4

6

5

(c)

4

6

5

FIG.34

(A) | Grip movement can be realized easily by appropriate grip operation |

　　　　└── | Concept 1 of compliant mechanism |

　　　　　　　└── | Compliant mechanism 1 |

(B) | What is the most suitable type of stopper for compliant mechanism 1 ? |

　　　　└── | Ratchet type |

　　　　　　　└── | Stopper 2 |

　　　　　　　　　├── | Very difficult to evaluate touch of ratchet mechanism |

　　　　　　　　　└── | Require a lot of processes for stopper of ratchet mechanism to act appropriately |

　　　　　　　　　　　　└── | No sufficient space to give stopper of ratchet mechanism |

　　　　　　　　　　　　　　　└── | Better to abandon to use ratchet mechanism |

(C) | How about using stopper of buckling type ? |

　　　　└── | Stopper 1 |

　　　　　　　└── | If plastics, stopper of buckling type functions well ? |

　　　　　　　　　├── | Difficult to make a draft of stopper of buckling type, although it is possible to design. |

　　　　　　　　　└── | Design becomes more difficult with deformation of each part getting bigger. |

(D) | What is the most suitable gripper interlocking with stopper of buckling type? |

　　　　└── | Concept 2 of compliant mechanism |

　　　　　　　├── | Difficult to use gripper of concept 2 |

　　　　　　　└── | Compliant mechanism 2 |

(E) | Design concept : combination of compliant mechanism 2 and stopper 2 |

　　　　└── | Since ratio of input displacement to output displacement is large, compliant mechanism 2 is difficult to interlock with the stopper 2. |

　　　　　　　└── | Necessary to make compliant mechanism whose ratio of input to output is small. |

　　　　　　　　　└── | Compliant mechanism 3 |

(F) | Design concept : combination of compliant mechanism 3 and stopper 2 |

　　　　└── | This concept acts well in this embodiment. |

## FIG.35

EP 1 783 643 A1

```
              ┌─────────────────────────────────────┐        ┌───────────────────────────────────────────────┐
              │ Concept 1 of compliant mechanism     │────────│ Optimal structure of compliant mechanism 1      │
              └─────────────────────────────────────┘        └───────────────────────────────────────────────┘
  ┌─────────┐ ╱
  │ Gripper │
  └─────────┘ ╲                                               ┌───────────────────────────────────────────────┐
              ┌─────────────────────────────────────┐     ╱──│ Optimal structure of compliant mechanism 2      │
              │ Concept 2 of compliant mechanism     │────    └───────────────────────────────────────────────┘
              └─────────────────────────────────────┘     ╲──┌───────────────────────────────────────────────┐
                                                              │ Optimal structure of compliant mechanism 3      │
                                                              └───────────────────────────────────────────────┘
```

```
              ┌─────────────────────────────────────┐        ┌──────────────┐
              │ Making use of buckling phenomenon    │────────│ Stopper 1    │
              └─────────────────────────────────────┘        └──────────────┘
  ┌─────────┐ ╱
  │ Stopper │
  └─────────┘ ╲
              ┌─────────────────────────────────────┐        ┌──────────────┐
              │ Making use of ratchet mechanism      │────────│ Stopper 2    │
              └─────────────────────────────────────┘        └──────────────┘
```

FIG.36

Input

D

Output

(a) Concept 1 of gripper 4

Input

D

Output

(b) Concept 2 of gripper 4

FIG.37

(a) Detail 1 of optimal structure FM

(b) Detail 2 of optimal structure FM

(c) Detail 3 of optimal structure FM

FIG.38

(a) Stopper 1

(b) Stopper 2

FIG.39

FIG.40

FIG.41

input point $P_{in}$

FIG.42

5

OS

4

41

411

FIG.43

FIG.44

## INTERNATIONAL SEARCH REPORT

| | International application No. |
|---|---|
| | PCT/JP2005/012892 |

### A. CLASSIFICATION OF SUBJECT MATTER
Int.Cl$^7$ G06F17/50

According to International Patent Classification (IPC) or to both national classification and IPC

### B. FIELDS SEARCHED

Minimum documentation searched (classification system followed by classification symbols)
Int.Cl$^7$ G06F17/50

Documentation searched other than minimum documentation to the extent that such documents are included in the fields searched

| Jitsuyo Shinan Koho | 1922-1996 | Jitsuyo Shinan Toroku Koho | 1996-2005 |
| Kokai Jitsuyo Shinan Koho | 1971-2005 | Toroku Jitsuyo Shinan Koho | 1994-2005 |

Electronic data base consulted during the international search (name of data base and, where practicable, search terms used)
JSTPlus(JOIS)

### C. DOCUMENTS CONSIDERED TO BE RELEVANT

| Category* | Citation of document, with indication, where appropriate, of the relevant passages | Relevant to claim No. |
|---|---|---|
| Y<br>A | Ryo HOSOYAMA et al., "Kaju Nyuryoku Ichi no Hen'i to Shutsuryoku Hen'i no Hi o Koryo shita Compliant Mechanism no Topology Saiteki Sekkeiho", The Japan Society of Mechanical Engineers 16th Computational Mechanics Conference, 22 November, 2003 (22.11.03), pages 881 to 882, full text, all drawings | 1-6,12,13<br>7-11 |
| Y<br>A | Masaru IGARASHI, "Jidosha Sekkei ni Okeru Kozo Kaiseki no Teikiyo", Hitachi Hyoron, Vol.75, No.5, 01 May, 1993 (01.05.93), pages 37 to 44; page 43, left column, line 23 to page 44, left column, line 5; Fig. 10 | 1-6,12,13<br>7-11 |

| ☐ | Further documents are listed in the continuation of Box C. | ☐ | See patent family annex. |
|---|---|---|---|

| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 15 August, 2005 (15.08.05) | 30 August, 2005 (30.08.05) |

| Name and mailing address of the ISA/ | Authorized officer |
|---|---|
| Japanese Patent Office | |
| Facsimile No. | Telephone No. |

Form PCT/ISA/210 (second sheet) (January 2004)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **NISHIWAKI, S. ; MIN, S. ; YOO, J. ; KIKUCHI, N.** Optimal Structural Design Considering Flexibility. *Comput. Methods Appl. Mech. Engrg,* 2001, vol. 190, 4457-4504
- **SIGMUND O.** On the Design of Compliant Mechanisms Using Topology Optimization. *Mech. Struct. & Mach.,* 1997, vol. 254, 493
- **HISASHI IHARA ; MASATOSHI SHIMODA ; HIDEYUKI AZEGAMI ; TOSHIAKI SAKURAI.** Shape Design by Integrating Shape Optimization with Topology Optimization for Multiobjective Structures (An Approach Using Homogenization Method and Traction Method. *Japan Society of Mechanical Engineers (A canto,* vol. 62 (596), 1091-1097
- **CHIREHDAST, M. ; GEA, H-D. ; KIKUCHI N. ; PAPALAMBROS, P. Y.** Structural Configuration Examples of an Integrated Optimal Design Process. *J. Mech. Design, Trans. ASME,* 1994, vol. 116, 997